# EUROPEAN PATENT APPLICATION

(11) **EP 4 432 360 A1**
(43) Date of publication of application: **18.09.2024**
(21) Application number: 22892995.6
(22) Date of filing: 06.09.2022
(51) Int. Cl.: H01L 27/12, H01L 25/075, H01L 33/62, H01L 33/48

(54) **DISPLAY DEVICE COMPRISING SEMICONDUCTOR LIGHT-EMITTING ELEMENTS**

(30) Priority: 10.11.2021 KR 20210153635
(71) Applicant: LG Electronics Inc., Yeongdeungpo-gu Seoul 07336 (KR); LG Display Co., Ltd., Seoul 07336 (KR)
(72) Inventor: CHOI, Wonseok, Seoul 06772 (KR); LEE, Sul, Paju-si Gyeonggi-do 10845 (KR); KIM, Minseok, Paju-si Gyeonggi-do 10845 (KR)
(74) Representative: Vossius & Partner Patentanwälte Rechtsanwälte mbB
(86) International application number: PCT/KR2022/013384
(87) International publication number: WO 2023/085572

(57) **Abstract**

A display device according to an embodiment includes: a substrate; a plurality of assembly lines disposed on the substrate and including first assembly lines and second assembly lines which are alternately arranged; a planarization layer having a plurality of openings which overlap the plurality of assembly lines respectively; a plurality of light-emitting elements disposed in the plurality of openings respectively; and a plurality of conductive connection members disposed in the plurality of openings respectively to electrically connect the plurality of assembly lines and the plurality of light-emitting elements to each other, wherein the planarization layer protrudes more inwardly of the plurality of openings than one end of the respective assembly lines, and one end of the respective assembly lines is exposed from the planarization layer and comes into contact with the plurality of conductive connection members.

## Description

### [Technical Field]

The present invention relates to a display device, and more specifically, to a display device using a semiconductor light emitting diode.

### [Background Art]

In display devices used in computer monitors, TVs, mobile phones, etc., there are organic light emitting displays (OLED) that emit light on their own, liquid crystal displays (LCD) and micro-LED that require a separate light source.

Micro-LED display is a display that uses micro-LED, a semiconductor light emitting device with a diameter or cross-sectional area of 100*µ*m or less, as a display element.

Micro-LED displays use micro-LED, a semiconductor light emitting device, as a display device, so Micro-LED displays have excellent performance in many characteristics such as contrast ratio, response speed, color gamut, viewing angle, brightness, resolution, lifespan, luminous efficiency, and luminance.

In particular, the micro-LED display has the advantage of being able to freely adjust the size and resolution and implement a flexible display because the screen may be separated and combined in a modular manner.

However, because large micro-LED displays require more than millions of micro-LEDs, there is a technical problem that makes it difficult to quickly and accurately transfer micro-LEDs to the display panel. Meanwhile, methods for transferring a semiconductor light emitting device to a substrate include a pick and place process, a laser lift-off method, or a self-assembly method.

Among these, the self-assembly method is a method in which a semiconductor light emitting device finds its assembly position within a fluid on its own, and is an advantageous method for implementing a large-screen display device.

Meanwhile, when transferring a light emitting device in a fluid, there is a problem that the assembly wiring is corroded by the fluid. Corrosion of the assembly wiring may cause an electrical short circuit and cause assembly defects.

### [Disclosure]

### [Technical Problem]

The technical object of the embodiment is to provide a display device that reduces the parasitic capacitance of the assembly wiring and improves the assembly rate of the light emitting device by placing a portion of the assembly wiring on the planarization layer.

Additionally, the technical object of the embodiment is to provide a display device with improved light extraction efficiency.

Additionally, the technical object of the embodiment is to provide a display device that may easily control the connection point of the assembly wiring and the Light emitting device.

In addition, the technical object of the embodiment is to provide a display device that utilizes the assembly wiring for self-assembly of the light emitting device as the wiring for driving the light emitting device.

The objects of the embodiment are not limited to the objects mentioned above, and other objects not mentioned will be clearly understood by those skilled in the art from the description below.

### [Technical Solution]

A display device including a light emitting device according to an embodiment may include a substrate, a plurality of assembly wirings disposed on the substrate and including first assembly wirings and second assembly wirings arranged alternately, a planarization layer having a plurality of openings overlapping the plurality of assembly lines, a plurality of light emitting devices disposed in each of the plurality of openings and a plurality of conductive connection members disposed in each of the plurality of openings and electrically connecting the plurality of assembly wirings and the plurality of light emitting devices.

The planarization layer protrudes inside the plurality of openings more than one end of the plurality of assembly wirings, and one end of the plurality of assembly wirings may be exposed from the planarization layer and may contact the plurality of conductive connection members.

Additionally, in the embodiment, the first assembly wiring may include a first conductive layer disposed on the substrate and a second conductive layer disposed on the first conductive layer, the second assembly wiring may include a third conductive layer disposed on the substrate, and a fourth conductive layer disposed on the third conductive layer, and the first conductive layer and the third conductive layer may overlap the plurality of openings, and the second conductive layer and the fourth conductive layer may be spaced apart from the openings.

In addition, the embodiment further includes a passivation layer disposed between the first conductive layer and the third conductive layer and the plurality of light emitting devices, the second conductive layer may be electrically connected to the first conductive layer through a contact hole in the passivation layer, and the fourth conductive layer may be electrically connected to the third conductive layer through a contact hole in the passivation layer.

Additionally, in the embodiment, in the plurality of openings, the sidewall of the planarization layer may be disposed closer to the plurality of light emitting devices than the second conductive layer and the fourth conductive layer.

In addition, in the embodiment, the planarization layer and the second conductive layer form an undercut structure, so that one end of the second conductive layer may be exposed from the planarization layer, and the plurality of conductive connection members may be filled inside the plurality of openings and may contact the lower side of the plurality of light emitting devices and one end of the second conductive layer.

In addition, in the embodiment, the planarization layer and the fourth conductive layer form an undercut structure, so that one end of the fourth conductive layer may be exposed from the planarization layer, and the plurality of conductive connection members may be filled inside the plurality of openings and may contact one end of the fourth conductive layer.

Additionally, in the embodiment, the planarization layer covers one end of the fourth conductive layer, and the plurality of conductive connection members may be separated from the fourth conductive layer by the planarization layer.

Additionally, the embodiment may further include a plurality of pixel electrodes disposed on the planarization layer and electrically connected to the plurality of light emitting devices and a plurality of insulating members disposed between the plurality of conductive connection members and the plurality of pixel electrodes in each of the plurality of openings.

Additionally, the embodiment further may include a plurality of driving transistors disposed between the substrate and the plurality of assembly wirings, and the plurality of pixel electrodes may electrically connect the plurality of driving transistors and the plurality of light emitting devices through contact holes in the planarization layer.

Additionally, the embodiment further includes a plurality of driving transistors disposed on the plurality of pixel electrodes, and the plurality of pixel electrodes may be reflective electrodes.

In addition, a display device including a semiconductor light emitting device according to an embodiment includes a substrate, a plurality of first conductive layers and a plurality of third conductive layers arranged alternately on the substrate and spaced apart from each other, a passivation layer disposed on the plurality of first conductive layers and the plurality of third conductive layers, a plurality of second conductive layers disposed on the passivation layer and electrically connected to each of the plurality of first conductive layers, a plurality of fourth conductive layers disposed on the passivation layer and electrically connected to each of the plurality of third conductive layers, a planarization layer disposed on the plurality of second conductive layers and the plurality of fourth conductive layers and having a plurality of openings overlapping with the plurality of first conductive layers and the plurality of third conductive layers.

Additionally, the embodiment may include a plurality of light emitting devices disposed in each of the plurality of openings, each of which includes a first semiconductor layer and a second semiconductor layer disposed on the first conductor layer and a plurality of conductive connection members surrounding the first semiconductor layer in the plurality of openings. One end of the plurality of second conductive layers may be exposed from the planarization layer and may contact the plurality of conductive connection members.

Additionally, in the embodiment, the planarization layer protrudes inside the plurality of openings beyond one end of the plurality of second conductive layers, and the planarization layer and the plurality of second conductive layers may form an undercut structure in which one end of the plurality of second conductive layers may be exposed from the planarization layer.

Additionally, in the embodiment, the planarization layer may include a first planarization layer disposed between the plurality of second conductive layers and the passivation layer and between the plurality of fourth conductive layers and the passivation layer and a second planarization layer disposed on the plurality of second conductive layers and the plurality of fourth conductive layers and including the plurality of openings, and a portion of the plurality of second conductive layers and a portion of the plurality of fourth conductive layers are disposed between the passivation layer and the second planarization layer, and the remaining portions of the plurality of second conductive layers and the remaining portions of the plurality of fourth conductive layers may be disposed between the first planarization layer and the second planarization layer.

Additionally, in the embodiment, one end of the plurality of fourth conductive layers may be exposed from the planarization layer and may contact the plurality of conductive connection members.

Additionally, in the embodiment, one end of the plurality of fourth conductive layers may be covered by the planarization layer and spaced apart from the plurality of conductive connection members.

Additionally, the embodiment may include a plurality of pixel electrodes disposed on the planarization layer and electrically connected to the second semiconductor layer of each of the plurality of light emitting devices and a plurality of insulating members surrounding the plurality of Light emitting devices between the plurality of pixel electrodes and the plurality of conductive connection members.

Additionally, the embodiment may further include a plurality of driving transistors disposed between the passivation layer and the substrate and electrically connected to the plurality of pixel electrodes.

Additionally, the embodiment further includes a plurality of driving transistors disposed on the plurality of pixel electrodes, and the plurality of pixel electrodes may form a gate electrode of the plurality of driving transistors and a storage capacitor.

Additionally, in the embodiment, the passivation layer may include a recess in an area in contact with the plurality of conductive connection members.

Additionally, in the embodiment, the plurality of conductive connection members and the assembly wiring may be disposed in the recess of the passivation layer.

### [Advantageous Effects]

According to the embodiment, there is a technical effect in that the wiring for self-assembly of the light emitting device may also be used as the wiring for driving the light emitting device.

In addition, the embodiment has the technical effect of minimizing defects during self-assembly or bonding of light emitting devices by improving the structure of a plurality of assembly wirings.

Additionally, the embodiment has the technical effect of minimizing short circuit defects in a plurality of assembly wiring.

Additionally, the embodiment has the technical effect of improving the resistance of a plurality of assembly wiring.

In addition, the embodiment has complex technical effects that may reduce the parasitic capacitance of a plurality of assembly wirings and improve the assembly rate of the light emitting device.

In addition, the embodiment forms a plurality of assembly wiring and planarization layers in an undercut structure, so that there is a special technical effect in that a plurality of assembly wirings and a light emitting device may be insulated during assembly, and a plurality of assembly wirings and a light emitting device may be easily electrically connected after assembly is completed.

In addition, the embodiment has the technical effect of simplifying the structure of the display device by configuring the display device in a bottom emission method.

In addition, the embodiment has the technical effect of improving the light extraction efficiency of the display device by configuring the display device in a bottom emission method.

In addition, the embodiment has the technical effect of preventing the issue of short-circuiting the wiring for driving the light emitting device by forming the conductive member thickly.

In addition, the embodiment has the technical effect of increasing the amount of current transmitted to the light emitting device when driving the light emitting device by increasing the contact area between the conductive member and the assembly wiring.

Effects according to the embodiment are not limited to the contents exemplified above, and further various effects are included within the present invention.

### [Description of Drawings]

FIG. 1 is a schematic plan view of a display device according to an embodiment.
FIG. 2 is an enlarged plan view of a display device according to an embodiment.
FIG. 3 is a cross-sectional view taken along line III-III' of FIG. 2.
FIGS. 4A to 4E are process diagrams for explaining a manufacturing method of a display device according to an embodiment.
FIG. 5 is an enlarged plan view of a display device according to a second embodiment.
FIG. 6 is a cross-sectional view taken along VI-VI' in FIG. 5.
FIG. 7 is a cross-sectional view of a display device according to the third embodiment.
FIG. 8 is a cross-sectional view of a display device according to a fourth embodiment.
FIG. 9 is a cross-sectional view of the display device 900 according to the fourth embodiment.

### [Mode for Invention]

Hereinafter, the embodiment disclosed in this specification will be described in detail with reference to the attached drawings. The suffixes 'module' and 'part' for components used in the following description are given or used interchangeably in consideration of ease of specification preparation, and do not have distinct meanings or roles in themselves. In addition, the attached drawings are intended to facilitate understanding of the embodiments disclosed in this specification, and the technical ideas disclosed in this specification are not limited by the attached drawings. Additionally, when an element such as a layer, region or substrate is referred to as being 'on' another component, this includes either directly on the other element or there may be other intermediate elements in between.

Display devices described in this specification include digital TVs, mobile phones, smart phones, laptop computers, digital broadcasting terminals, PDAs (personal digital assistants), PMPs (portable multimedia players), navigation, Slate PCs, Tablet PCs, Ultra-Books, desktop computers, etc. However, the configuration according to the embodiment described in this specification may be applied to a device capable of displaying, even if it is a new product type that will be developed in the future.

Hereinafter, the embodiment will be described with reference to the drawings.

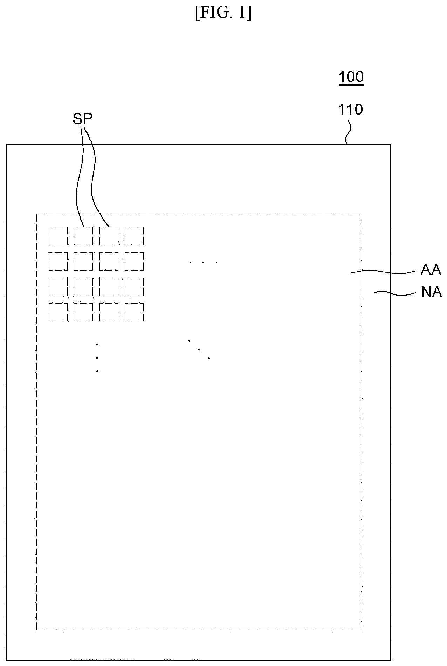

FIG. 1 is a schematic plan view of a display device according to an embodiment. For convenience of explanation, only the substrate 110 and the plurality of sub-pixels (SP) among the various components of the display device 100 are shown in FIG. 1.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

The substrate 110 is configured to support various components included in the display device 100, and may be made of an insulating material. For example, the substrate 110 may be made of glass or resin. Additionally, the substrate 110 may include polymer or plastic, or may be made of a material with flexibility.

The substrate 110 includes a display area (AA) and a non-display area (NA).

The display area (AA) is an area where a plurality of sub-pixels (SP) are arranged and an image is displayed. Each of the plurality of sub-pixels (SP) is an individual unit that emits light, and a light emitting device and a driving circuit are formed in each of the plurality of sub-pixels (SP). For example, the plurality of sub-pixels SP may include, but are not limited to, a red sub-pixel, a green sub-pixel, a blue sub-pixel, and/or a white sub-pixel.

The non-display area (NA) is an area where images are not displayed, and is an area where various wiring, driver ICs, etc. for driving the sub-pixels (SP) arranged in the display area (AA) are placed. For example, various ICs such as gate driver ICs and data driver ICs and driving circuits may be placed in the non-display area (NA). Meanwhile, the non-display area NA may be located on the back of the substrate 110 that is, on the side without the sub-pixel SP, or may be omitted, and is not limited to what is shown in the drawing.

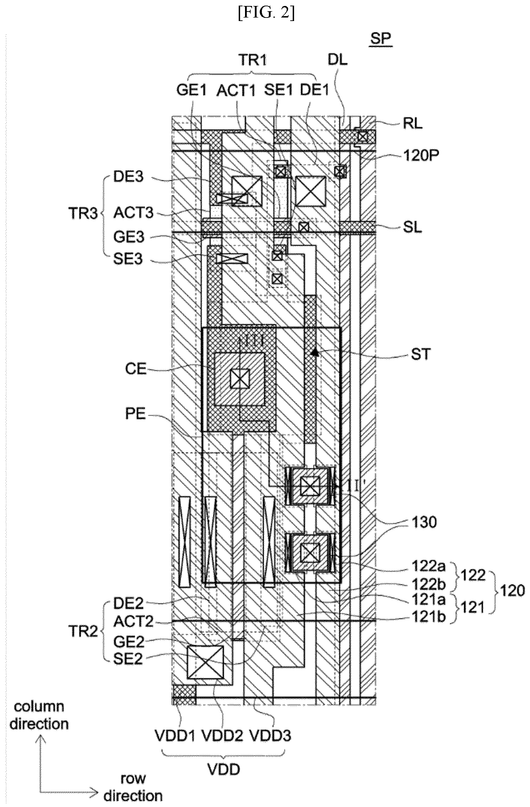

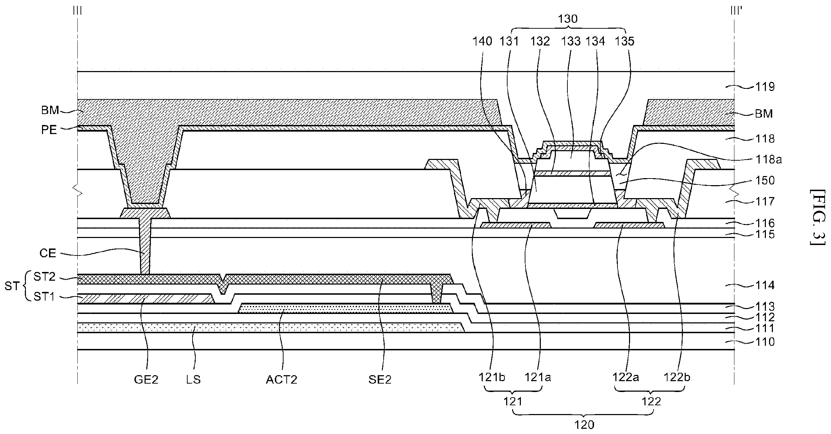

The display device 100 of the embodiment may drive the light emitting device in an active matrix (AM, Active Matrix) method or a passive matrix (PM, Passive Matrix) method. Hereinafter, FIGS. 2 and 3 will be referred to together for a more detailed description of the plurality of sub-pixels (SP).

FIG. 2 is an enlarged plan view of a display device according to an embodiment. FIG. 3 is a cross-sectional view taken along line III-III' of FIG. 2. 2 and 3, the display device 100 according to the embodiment may include a scan line (SL), a data line (DL), a high potential power line VDD, a plurality of assembly wirings 120, a reference wiring (RL), a first transistor (TR1), second transistor, third transistor, storage capacitor (ST), semiconductor light emitting device 130, conductive connection member 140, insulating member 150, light blocking layer (LS), buffer layer 111, gate insulating layer 113, multiple passivation layers, multiple planarization layers, connection electrode (CE), pixel electrode (PE), assembly wiring connection pattern 120P, black matrix (BM), and protective layer 119, etc.

Referring to FIGS. 2 and 3, a plurality of data wires (DL), a first layer VDD1 and a second layer VDD2 of the high-potential power wire VDD, a plurality of reference wires (RL), and a plurality of assembly wirings 120 extend in the column direction, and the third layer VDD3 of the plurality of scan lines SL and the high potential power line VDD extends in the row direction. Additionally, a first transistor TR1, a second transistor, a third transistor, and a storage capacitor ST may be disposed in each of the plurality of sub-pixels SP.

First, the first layer VDD1 of the high-potential power line VDD may be disposed on the substrate 110. The high-potential power supply line VDD is a line that transmits a high-potential power supply voltage to each of the plurality of sub-pixels (SP) and includes a first layer VDD1, a second layer VDD2, and a third layer VDD3. The first layer VDD1 of the high-potential power supply line VDD may extend in the column direction in each of the plurality of sub-pixels (SP).

The light blocking layer LS may be disposed on the substrate 110. The light blocking layer LS is disposed on the same layer as the first layer VDD1 of the high potential power supply line VDD and may be made of the same material. The light blocking layer LS blocks light incident from the bottom of the substrate 110 to the second active layer ACT2 of the second transistor, which will be described later, and may minimize leakage current.

The buffer layer 111 may be disposed on the first layer VDD1 and the light blocking layer (LS) of the high-potential power line VDD. The buffer layer 111 may reduce penetration of moisture or impurities through the substrate 110. The buffer layer 111 may be composed of, for example, a single layer or a multiple layer of silicon oxide (SiOx) or silicon nitride (SiNx), but is not limited thereto. However, the buffer layer 111 may be omitted depending on the type of substrate 110 or the type of transistor, but is not limited thereto.

A plurality of scan wires (SL), a plurality of reference wires (RL), a plurality of data wires (DL), a first transistor (TR1), a second transistor, a third transistor, and a storage capacitor (ST) may be disposed on the buffer layer 111.

First, the first transistor TR1 includes a first active layer ACT1, a first gate electrode GE1, a first source electrode SE1, and a first drain electrode DE1. The first active layer (ACT1) may be disposed on the buffer layer 111. The first active layer (ACT1) may be made of a semiconductor material such as oxide semiconductor, amorphous silicon, or polysilicon, but is not limited thereto.

The gate insulating layer 113 may be disposed on the first active layer ACT1. The gate insulating layer 113 is an insulating layer for insulating the first active layer (ACT1) and the first gate electrode (GE1), and may be composed of a single layer or multiple layers of silicon oxide (SiOx) or silicon nitride (SiNx), but is not limited thereto.

The first gate electrode GE1 may be disposed on the gate insulating layer 113. The first gate electrode GE1 may be electrically connected to the scan line SL. The first gate electrode GE1 is made of a conductive material, such as copper (Cu), aluminum (Al), molybdenum (Mo), nickel (Ni), titanium (Ti), chromium (Cr), or an alloy thereof, but is not limited to this.

The first passivation layer 112 may be disposed on the first gate electrode GE1. Contact holes may be formed in the first passivation layer 112 to connect the first source electrode SE1 and the first drain electrode DE1 to the first active layer ACT1. The first passivation layer 112 is an insulating layer to protect the structure below the first passivation layer 112, and may be composed of a single layer or multiple layers of silicon oxide (SiOx) or silicon nitride (SiNx), but is not limited to this.

A first source electrode (SE1) and a first drain electrode (DE1) electrically connected to the first active layer (ACT1) are disposed on the first passivation layer 112. The first drain electrode DE1 may be connected to the data line DL, and the first source electrode SE1 may be connected to the second gate electrode GE2 of the second transistor. The first source electrode (SE1) and the first drain electrode (DE1) are made of a conductive material, for example, copper (Cu), aluminum (Al), molybdenum (Mo), nickel (Ni), titanium (Ti), chromium (Cr) or an alloy thereof, but is not limited thereto.

Meanwhile, in the embodiment, the first source electrode SE1 and the first drain electrode DE1 were described as being connected to the second gate electrode GE2 and the data line DL, respectively, but depending on the type of transistor, the first source electrode SE1 may be connected to the data line DL, and the first drain electrode DE1 may be connected to the second gate electrode GE2 of the second transistor, but is not limited thereto.

The first gate electrode GE1 of the first transistor TR1 is connected to the scan line SL, and may be turned on or off depending on the scan signal. The first transistor TR1 may transmit a data voltage to the second gate electrode GE2 of the second transistor based on the scan signal, and may be referred to as a switching transistor.

Meanwhile, a plurality of data lines DL and a plurality of reference lines RL may be disposed on the gate insulating layer 113 along with the first gate electrode GE1. The plurality of data lines DL and the reference lines RL may be formed of the same material and process as the first gate electrode GE1.

The plurality of data lines DL are lines that transmit data voltages to each of the plurality of sub-pixels SP. The plurality of data lines DL may transmit data voltage to the first transistor TR1 of each of the plurality of sub-pixels SP.

The plurality of reference wires RL are wires that transmit a reference voltage to each of the plurality of sub-pixels SP. The plurality of reference lines RL may transmit the reference voltage to the third transistor of each of the plurality of sub-pixels SP.

A second transistor may be disposed in each of the plurality of sub-pixels SP. The second transistor may include a second active layer (ACT2), a second gate electrode (GE2), a second source electrode (SE2), and a second drain electrode (DE2). The second active layer (ACT2) may be disposed on the buffer layer 111. The second active layer (ACT2) may be made of a semiconductor material such as oxide semiconductor, amorphous silicon, or polysilicon, but is not limited thereto.

The gate insulating layer 113 may be disposed on the second active layer ACT2, and the second gate electrode GE2 may be disposed on the gate insulating layer 113. The second gate electrode GE2 may be electrically connected to the first source electrode SE1 of the first transistor TR1. The second gate electrode GE2 is made of a conductive material, such as copper (Cu), aluminum (Al), molybdenum (Mo), nickel (Ni), titanium (Ti), chromium (Cr), or an alloy thereof, but is not limited to this.

The first passivation layer 112 is disposed on the second gate electrode GE2, and the second source electrode SE2 and the second drain electrode DE2 may be disposed on the first passivation layer 112. The second source electrode SE2 is electrically connected to the second active layer ACT2. The second drain electrode DE2 is electrically connected to the second active layer ACT2 and at the same time is electrically connected to the high potential power supply line VDD. The second drain electrode DE2 may be disposed between the first layer VDD1 and the second layer VDD2 of the high potential power line VDD and electrically connected to the high potential power line VDD.

The second gate electrode (GE2) of the second transistor is connected to the first source electrode (SE1) of the first transistor (TR1), so the second transistor may be turned on by the data voltage transmitted when the first transistor TR1 is turned on. And the turned-on second transistor may transfer driving current to the light emitting device 130 based on the high-potential power supply voltage from the high-potential power supply line VDD, so it may be referred to as a driving transistor.

A third transistor may be disposed in each of the plurality of sub-pixels (SP). The third transistor includes a third active layer (ACT3), a third gate electrode (GE3), a third source electrode (SE3), and a third drain electrode (DE3). The third active layer (ACT3) may be disposed on the buffer layer 111. The third active layer (ACT3) may be made of a semiconductor material such as oxide semiconductor, amorphous silicon, or polysilicon, but is not limited thereto.

The gate insulating layer 113 may be disposed on the third active layer ACT3, and the third gate electrode GE3 may be disposed on the gate insulating layer 113. The third gate electrode GE3 is electrically connected to the scan line SL, and the third transistor may be turned on or off by a scan signal from the scan line SL. The third gate electrode GE3 is made of a conductive material, such as copper (Cu), aluminum (Al), molybdenum (Mo), nickel (Ni), titanium (Ti), chromium (Cr), or an alloy thereof, but is not limited to this.

However, it was explained that the third gate electrode (GE3) and the first gate electrode (GE1) were connected to the same scan line (SL), but the third gate electrode GE3 may be connected to a different scan line SL from the first gate electrode GE1, but is not limited thereto.

The first passivation layer 112 is disposed on the third gate electrode GE3, and a third source electrode (SE3) and a third drain electrode (DE3) may be disposed on the first passivation layer 112. The third source electrode SE3 may be formed integrally with the second source electrode SE2, and may be electrically connected to the third active layer ACT3 and simultaneously electrically connected to the second source electrode SE2 of the second transistor. And the third drain electrode DE3 may be electrically connected to the reference wiring RL.

The third transistor electrically connected to the second source electrode (SE2), reference line (RL), and storage capacitor (ST) of the second transistor, which is the driving transistor, may be referred to as a sensing transistor.

A storage capacitor (ST) may be disposed in each of the plurality of sub-pixels (SP). The storage capacitor ST includes a first capacitor electrode ST1 and a second capacitor electrode ST2. The storage capacitor (ST) is connected between the second gate electrode (GE2) and the second source electrode (SE2) of the second transistor, and may maintain the voltage level of the gate electrode of the second transistor constant while the light emitting device 130 emits light.

The first capacitor electrode (ST1) may be integrated with the second gate electrode (GE2) of the second transistor. Accordingly, the first capacitor electrode ST1 may be electrically connected to the second gate electrode GE2 of the second transistor and the first source electrode SE1 of the first transistor TR1.

The capacitor electrode ST2 may be disposed on the first capacitor electrode ST1 with the first passivation layer 112 interposed therebetween. The second capacitor electrode ST2 may be integrated with the second source electrode SE2 of the second transistor and the third source electrode SE3 of the third transistor. Accordingly, the second capacitor electrode ST2 may be electrically connected to the second transistor and the third transistor.

Meanwhile, a plurality of scan lines SL may be disposed on the first passivation layer 112 along with the first source electrode (SE1), the first drain electrode (DE1), the second source electrode (SE2), the second drain electrode (DE2), the third source electrode SE3, third drain electrode DE3, and second capacitor electrode ST2.

The plurality of scan wires SL are wires that transmit scan signals to each of the plurality of sub-pixels SP. The plurality of scan lines SL may transmit scan signals to the first transistor TR1 of each of the plurality of sub-pixels SP. For example, each of the plurality of scan lines SL extends in the row direction and may transmit a scan signal to a plurality of sub-pixels SP arranged in the same row.

Next, an over coating layer 114 is disposed on a plurality of scan wires (SL), a plurality of reference wires (RL), a plurality of data wires (DL), a first transistor (TR1), a second transistor, a third transistor, and a storage capacitor (ST). The overcoating layer 114 may planarize the upper part of the substrate 110 on which the plurality of transistors are disposed. The overcoating layer 114 may be composed of a single layer or a double layer, and may be made of, for example, an acryl-based organic material, but is not limited thereto.

The second passivation layer 115 may be disposed on the overcoating layer 114. The second passivation layer 115 is an insulating layer for protecting the structure below the second passivation layer 115 and improving the adhesion of the structure formed on the second passivation layer 115, and may be composed of a single layer or multiple layers of silicon oxide (SiOx) or silicon nitride (SiNx), but is not limited thereto. However, the second passivation layer 115 may be omitted depending on the design, but is not limited thereto.

A second layer VDD2 of the high-potential power supply line VDD, a plurality of assembly lines 120, and a connection electrode (CE) may be disposed on the second passivation layer 115.

The second layer VDD2 extends in the column direction between each of the plurality of sub-pixels SP and may overlap the first layer VDD1. The first layer VDD 1 and the second layer VDD2 may be electrically connected through a contact hole formed in the insulating layers formed between the first layer VDD1 and the second layer VDD2. The second layer VDD2 may be formed of the same material and the same process as the first conductive layer 121a or the second conductive layer 121b of the first assembly wiring 121, but is not limited thereto.

The plurality of assembly wirings 120 generate an electric field for aligning the plurality of Light emitting devices 130 when manufacturing the display device 100, and are a wiring that supplies low-potential power voltage to the plurality of light emitting devices 130 when the display device 100 is driven. Accordingly, the assembly wiring 120 may be referred to as a low-potential power wiring. The plurality of assembly wirings 120 are arranged in a column direction along the plurality of sub-pixels SP arranged on the same line. The plurality of assembly wirings 120 may be arranged to overlap the plurality of sub-pixels SP arranged in the same column. One pair of assembly wirings 120 among the plurality of assembly wirings 120 may be arranged to overlap one sub-pixel SP.

The plurality of assembly wirings 120 may be made of a conductive material, such as copper (Cu), chromium (Cr), molybdenum (Mo), or molybdenum titanium (MoTi), but are not limited thereto.

The plurality of assembly wirings 120 includes a plurality of first assembly wirings 121 and a plurality of second assembly wirings 122. The plurality of first assembly wirings 121 and the plurality of second assembly wirings 122 may be alternately arranged. Additionally, in each of the plurality of sub-pixels SP, one first assembly wiring 121 and one second assembly wiring 122 may be disposed adjacent to each other.

Each of the plurality of first assembly wirings 121 may include a first conductive layer 121a and a second conductive layer 121b. The first conductive layer 121a may be disposed on the second passivation layer 115. The first conductive layer 121a is arranged to overlap the opening 118a where the plurality of light emitting devices 130 are seated. For example, the first conductive layer 121a may be arranged so that at least a portion of the first conductive layer 121a overlaps the opening 118a.

The third passivation layer 116 may be disposed on the first conductive layer 121a. The third passivation layer 116 is an insulating layer to protect the structure below the third passivation layer 116 and to improve the adhesion of the structure formed on the third passivation layer 116, and may be composed of a single layer or multiple layers of silicon oxide (SiOx) or silicon nitride (SiNx), but is not limited thereto.

And the third passivation layer 116 is arranged to cover the first conductive layer 121a of the first assembly wiring 121 overlapping the plurality of openings 118a. Accordingly, the first conductive layer 121a and the light emitting device 130 may not be directly connected by the third passivation layer 116 covering the first conductive layer 121a.

The first planarization layer 117 may be disposed on the third passivation layer 116. The first planarization layer 117 may be formed so as not to overlap the first conductive layer 121a of the first assembly wiring 121. A portion of the third passivation layer 116 covering the first conductive layer 121a may be exposed from the first planarization layer 117. The first planarization layer 117 may be composed of a single layer or a double layer, and may be made of, for example, an acryl-based organic material, but is not limited thereto.

The second conductive layer 121b of each of the plurality of first assembly wirings 121 may be disposed on the first planarization layer 117. A portion of the second conductive layer 121b is disposed on the third passivation layer 116 and the first conductive layer 121a,

The remaining portion of the second conductive layer 121b may be disposed on the first planarization layer 117. The second conductive layer 121b may be electrically connected to the first conductive layer 121a through a contact hole formed in the third passivation layer 116.

Meanwhile, the second conductive layer 121b of the first assembly wiring 121 extends in the column direction on the substrate 110 and may be disposed in a plurality of sub-pixels SP on the same line. That is, the second conductive layer 121b may be arranged in the form of a wire crossing a plurality of sub-pixels (SP). In contrast, the first conductive layer 121a may be a conductive pattern arranged to correspond to a plurality of openings 118a. The first conductive layer 121a may be partially disposed to correspond only to the plurality of openings 118a. For example, one first assembly wiring 121 may be comprised of a plurality of first conductive layers 121a overlapping each of the plurality of openings 118a and a second conductive layer 121b connected to the plurality of first conductive layers 121a.

Meanwhile, the thickness of the first conductive layer 121a overlapping the opening 118a may be thinner than the thickness of the second conductive layer 121b. By reducing the thickness of the first conductive layer 121a overlapping the opening 118a, the light emitting device 130 may be stably self-assembled within the opening 118a. If the thickness of the first conductive layer 121a of each of the plurality of first assembly wirings 121 is thick, the depth of the opening 118a may be reduced, making it difficult for the light emitting device 130 to be stably placed. However, when reducing the thickness of the first conductive layer 121a, the depth of the opening 118a may be secured, and the step between the area where the first conductive layer 121a is placed and the area where the first conductive layer 121a is not placed may be reduced.

Therefore, there is a technical effect in that the light emitting device 130 may be stably self-assembled within the opening 118a by forming a relatively thin thickness of the first conductive layer 121a overlapping the opening 118a.

Meanwhile, as the thickness of the first conductive layer 121a decreases, resistance increases and problems such as heat generation may occur. Accordingly, by increasing the thickness of the second conductive layer 121b connected to the first conductive layer 121a, the resistance of the plurality of first assembly wirings 121 may be lowered. In addition, when the first conductive layer 121a, which has a relatively thin thickness and high resistance, is formed in the form of a wiring like the second conductive layer 121b, problems such as heat generation may occur due to resistance. Accordingly, only the second conductive layer 121b, which has a relatively thick thickness, is formed in the form of a wire crossing the plurality of sub-pixels (SP), so there is a technical effect of minimizing problems such as heat generation or power consumption due to resistance in the first assembly wiring 121.

Meanwhile, the remaining portion of the second conductive layer 121b is disposed on the first planarization layer 117 except for the portion in contact with the first conductive layer 121a. When self-assembling the light emitting device 130, parasitic capacitance may occur between the second conductive layer 121b arranged along the plurality of sub-pixels (SP) arranged on the same line and various wires arranged in each of the plurality of sub-pixels (SP). For example, parasitic capacitance may occur between the second conductive layer 121b and the data line DL.

In this case, the voltage applied to the second conductive layer 121b may change due to parasitic capacitance, and the self-assembly rate of the light emitting device 130 may decrease. Accordingly, by placing the second conductive layer 121b on the first planarization layer 117, there is a technical effect of increasing the gap between the second conductive layer 121b and various wiring under the first planarization layer 117 and the overcoating layer 114 and reducing parasitic capacitance.

Each of the plurality of second assembly wirings 122 includes a third conductive layer 122a and a fourth conductive layer 122b. A third conductive layer 122a may be disposed on the second passivation layer 115. The third conductive layer 122a is arranged to overlap the opening118a where the plurality of light emitting devices 130 are seated. And the third conductive layer 122a may be disposed adjacent to the first conductive layer 121a of the first assembly wiring 121. For example, one first conductive layer 121a and one third conductive layer 122a may be arranged to overlap one opening 118a.

The third passivation layer 116 is disposed on the third conductive layer 122a. Since the third passivation layer 116 is disposed between the third conductive layer 122a and the light emitting device 130, the third conductive layer 122a and the light emitting device 130 may not be directly connected.

The first planarization layer 117 may be disposed on the third passivation layer 116. The first planarization layer 117 may be formed so as not to overlap the third conductive layer 122a of the second assembly wiring 122. A portion of the third passivation layer 116 covering the third conductive layer 122a may be exposed from the first planarization layer 117.

The fourth conductive layer 122b of each of the plurality of second assembly wirings 122 is disposed on the first planarization layer 117. A portion of the fourth conductive layer 122b may be disposed on the third passivation layer 116 and the third conductive layer 122a, and the remaining portion of the fourth conductive layer 122b may be disposed on the first planarization layer 117. The fourth conductive layer 122b may be electrically connected to the third conductive layer 122a through a contact hole formed in the third passivation layer 116. Meanwhile, the fourth conductive layer 122b of the second assembly wiring 122 also extends in the column direction on the substrate 110 like the second conductive layer 121b of the first assembly wiring 121, and may be arranged in a plurality of sub-pixels (SP) on the same line. That is, the fourth conductive layer 122b may be arranged in the form of a wire crossing a plurality of sub-pixels (SP). Alternatively, the third conductive layer 122a may be a conductive pattern arranged to correspond to a plurality of openings 118a. The third conductive layer 122a may be partially arranged to correspond only to the plurality of openings 118a. For example, one second assembly wiring 122 may be composed of a plurality of third conductive layers 122a overlapping each of the plurality of openings 118a and a fourth conductive layer 122b connected to the plurality of third conductive layers 122a.

Meanwhile, the thickness of the third conductive layer 122a overlapping the opening118a may be thinner than the thickness of the fourth conductive layer 122b. By reducing the thickness of the third conductive layer 122a overlapping the opening118a, the light emitting device 130 may be stably self-assembled within the opening118a. If the thickness of the third conductive layer 122a of each of the plurality of second assembly wirings 122 is thick, the depth of the opening 118a may decrease, making it difficult to stably arrange the light emitting device 130. However, when the thickness of the third conductive layer 122a is reduced, the depth of the opening 118a may be secured and the step between the area where the third conductive layer 122a is placed and the area where the third conductive layer 122a is not placed may be reduced. Therefore, the light emitting device 130 may be stably self-assembled within the opening118a by forming the third conductive layer 122a overlapping the plurality of openings118a to be relatively thin.

Meanwhile, as the thickness of the third conductive layer 122a decreases, resistance increases and problems such as heat generation may occur. Accordingly, by increasing the thickness of the fourth conductive layer 122b connected to the third conductive layer 122a, the resistance of the plurality of second assembly wirings 122 may be lowered. Additionally, when the third conductive layer 122a, which has a relatively thin thickness and high resistance, is formed in the form of a wiring like the fourth conductive layer 122b, problems such as heat generation may occur due to resistance. Accordingly, only the fourth conductive layer 122b, which has a relatively thick thickness, is formed in the form of a wire crossing the plurality of sub-pixels (SP), problems such as heat generation or power consumption due to resistance in the second assembly wiring 122 may be minimized.

Meanwhile, the remaining portion of the fourth conductive layer 122b may be disposed on the first planarization layer 117 except for the portion in contact with the third conductive layer 122a. When self-assembling the light emitting device 130, parasitic capacitance may occur between the fourth conductive layer 122b arranged along the plurality of sub-pixels (SP) arranged on the same line and various wires arranged in each of the plurality of sub-pixels (SP). In this case, the voltage applied to the fourth conductive layer 122b may change due to parasitic capacitance, and the self-assembly rate of the light emitting device 130 may decrease. Accordingly, the fourth conductive layer 122b is disposed on the first planarization layer 117, so that the gap between the fourth conductive layer 122b and various wiring under the first planarization layer 117 and the overcoating layer 114 may be increased, and parasitic capacitance may be reduced.

A connection electrode (CE) may be disposed in each of the plurality of sub-pixels (SP). The connection electrode CE is electrically connected to the second capacitor electrode ST2 and the second source electrode SE2 of the second transistor through a contact hole formed in the second passivation layer 115. The connection electrode (CE) is an electrode for electrically connecting the Light emitting device 130 and the second transistor, which is a driving transistor. For example, the connection electrode CE may be formed of the same material on the same layer as the first conductive layer 121a and/or the second conductive layer 121b of the first assembly wiring 121. However, the connection electrode CE may be formed of a material other than the assembly wiring 120, but is not limited thereto.

The second planarization layer 118 may be disposed on the plurality of assembly wirings 120 and the connection electrode CE. The second planarization layer 118 may be disposed to cover the plurality of assembly lines 120. The second planarization layer 118 may be composed of a single layer or a double layer, and may be made of, for example, an acryl-based organic material, but is not limited thereto.

Meanwhile, a portion of the second planarization layer 118 overlapping the first conductive layer 121a of the first assembly wiring 121 and the third conductive layer 122a of the second assembly wiring 122 is open, so an opening118a in which the plurality of light emitting devices 130 are seated may be formed. One or more opening118a may be arranged in one sub-pixel (SP). For example, one opening118a or two opening118a may be disposed in one sub-pixel (SP). The plurality of openings118a are grooves in which the plurality of light emitting devices 130 are disposed and may be referred to as pockets, etc. The plurality of openings1 18a may be formed to overlap the plurality of assembly wirings 120. One opening118a may overlap a pair of assembly lines 120 arranged adjacent to each other in one sub-pixel SP.

For example, the opening118a of the second planarization layer 118 may overlap the first conductive layer 121a of the first assembly wiring 121 and the third conductive layer 122a of the second assembly wiring 122. Accordingly, the light emitting device 130 may be self-assembled within the opening118a by the electric field between the pair of assembly wirings 120 overlapping the plurality of openings118a.

Meanwhile, the second planarization layer 118 protrudes inside the opening118a beyond the second conductive layer 121b of the first assembly wiring 121 and the fourth conductive layer 122b of the second assembly wiring 122. In opening118a, the sidewall of the second planarization layer 118 is disposed closer to the light emitting device 130 than one end of the second conductive layer 121b and one end of the fourth conductive layer 122b. As the second planarization layer 118 protrudes more inside the opening118a than the second conductive layer 121b and the fourth conductive layer 122b, when assembling the light emitting device 130, direct contact between the second conductive layer 121b and the fourth conductive layer 122b and the light emitting device 130 may be prevented.

At this time, in the plurality of openings 118a, the second conductive layer 121b and the second planarization layer 118, the fourth conductive layer 122b and the second planarization layer 118 may form an undercut structure. The second planarization layer 118 is disposed to cover the second conductive layer 121b and the fourth conductive layer 122b, but the lower portion of the side wall of the second planarization layer 118 in opening 118a is.

The space from opening1 18a to one end of the second conductive layer 121b and the space from opening118a to one end of the fourth conductive layer 122b are not filled with the second planarization layer 118, the end of the second conductive layer 121b and the end of the fourth conductive layer 122b may be exposed from the second planarization layer 118.

A plurality of light emitting devices 130 may be disposed in each of the plurality of openings 118a. The plurality of light emitting devices 130 are light emitting devices 130 that emit light by electric current. The plurality of light emitting devices 130 may include light emitting devices 130 that emit red light, green light, blue light, etc., and a combination of these may produce light of various colors, including white. In addition, the plurality of light emitting devices 130 are composed of light emitting devices 130 that emit light of the same color, images of various colors may be displayed using a separate light conversion member that converts light from the plurality of light emitting devices 130 into light of different colors, but is not limited thereto. For example, the light emitting device 130 may be a light emitting diode (LED) or a micro LED, but is not limited thereto.

Each of the plurality of light emitting devices 130 includes a first semiconductor layer 131, a second semiconductor layer 133, a light emitting layer 132, a first electrode 134, and a second electrode 135.

Referring to FIG. 3, the second semiconductor layer 133 may be disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may include an AlInGaP-based semiconductor layer, for example, AlInGaP-based semiconductor layer may be a layer doped with a p-type or n-type impurity in a material such as indium aluminum phosphide (InAlP) or gallium arsenide (GaAs). The p-type impurities may be magnesium (Mg), zinc (Zn), beryllium (Be), etc., and the n-type impurities may be silicon (Si), germanium (Ge), tin (Sn), etc., but are not limited thereto.

The light emitting layer 132 may be disposed between the first semiconductor layer 131 and the second semiconductor layer 133. The light emitting layer 132 may emit light by receiving holes and electrons from the first semiconductor layer 131 and the second semiconductor layer 133. The light-emitting layer 132 may be made of a single-layer or multi-quantum well (MQW) structure, and may be made of, for example, indium gallium nitride (InGaN) or gallium nitride (GaN), but is not limited thereto.

The first electrode 134 is disposed on the lower surface of the first semiconductor layer 131, and the second electrode 135 is disposed on the upper surface of the second semiconductor layer 133. The first electrode 134 is an electrode electrically connected to the assembly wiring 120, and the second electrode 135 is an electrode that electrically connects a pixel electrode (PE), which will be described later, and the second semiconductor layer 133. The first electrode 134 and the second electrode 135 may be formed of a conductive material. However, the first electrode 134 may be omitted depending on the design, but is not limited thereto.

Meanwhile, although not shown in the drawing, an insulating layer surrounding a portion of each of the plurality of light emitting devices 130 may be disposed. Specifically, the insulating layer may cover at least the side surface of the light emitting device 130 among the outer surfaces of the plurality of light emitting devices 130. An insulating layer is formed on the light emitting device 130 to protect the light emitting device 130, and when forming the first electrode 134 and the second electrode 135, and may prevent electrical short circuit between the first semiconductor layer 131 and the second semiconductor layer 133.

A conductive connection member 140 surrounding the lower side of the light emitting device 130 is disposed in opening118a. The conductive connection member 140 is filled in the space inside the opening1 18a and may fix the light emitting device 130. Additionally, the conductive connection member 140 is filled inside the opening118a and may electrically connect the first semiconductor layer 131 and the first electrode 134 of the light emitting device 130 and the assembly wiring 120. For example, the conductive connection member 140 surrounding the first semiconductor layer 131 and the first electrode 134 fills the empty space between the second planarization layer 118 and the third passivation layer 116 and may contact the second conductive layer 121b.

Accordingly, the second conductive layer 121b of the assembly wiring 120 and the first semiconductor layer 131 of the light emitting device 130 may be electrically connected by the conductive connection member 140. The conductive connection member 140 is made of a conductive material such as silver (Ag) and may be formed through an inkjet printing process, but is not limited thereto.

An insulating member 150 is disposed inside the opening118a. The insulating member 150 is filled inside the opening118a, may cover the conductive connection member 140, and may surround the side of the light emitting device 130. For example, the insulating member 150 may surround a portion of the side of the light emitting device 130 including the light-emitting layer 132 and cover all of the conductive connection member 140 exposed at opening118a. Accordingly, there is a technical effect of preventing short circuit defects from occurring by electrically connecting the pixel electrode (PE) and the conductive connection member 140, which will be described later.

The pixel electrode (PE) is disposed on the insulating member 150 and the second planarization layer 118. The pixel electrode (PE) is an electrode for electrically connecting the plurality of light emitting devices 130 and the connection electrode (CE). The pixel electrode PE may be electrically connected to the light emitting device 130 of opening118a and the connection electrode CE through a contact hole formed in the second planarization layer 118 and the first planarization layer 117. Accordingly, the second electrode 135 of the light emitting device 130, the connection electrode CE, and the second transistor may be electrically connected to each other through the pixel electrode PE.

Meanwhile, the display device 100 may be configured as a top emission or bottom emission method depending on the direction in which light emitted from the Light emitting device 130 is emitted.

The top emission method is a method in which light emitted from the light emitting device 130 is emitted toward the top of the substrate 110 on which the light emitting device 130 is disposed. In the case of the top emission method, a reflective layer may be formed below the light emitting device 130 in order to advance the light emitted from the light emitting device 130 to the upper part of the substrate 110, that is, toward the pixel electrode (PE). In this case, the pixel electrode PE may be made of a transparent conductive material.

The bottom emission method is a method in which light emitted from the light emitting device 130 is emitted from the lower portion of the substrate 110 on which the light emitting device 130 is disposed. In the case of the bottom emission method, in order to allow the light emitted from the light emitting device 130 to proceed to the lower part of the substrate 110, the pixel electrode PE may be made of a metal material with high reflectivity.

Hereinafter, the description will be made on the assumption that the display device 100 according to the embodiment is a top emission method, but is not limited thereto.

Since the display device 100 according to the embodiment is a top emission type, the pixel electrode PE may be made of a transparent conductive material. For example, the pixel electrode (PE) may be formed of a transparent conductive material such as indium tin oxide (ITO), indium zinc oxide (IZO), etc., but is not limited thereto.

And the first conductive layer 121a and the third conductive layer 122a below the light emitting device 130, The second conductive layer 121b and the fourth conductive layer 122b on the side of the light emitting device 130 and the conductive connection member 140 surrounding the side of the light emitting device 130 has a high reflectivity and is made of an opaque metal material, so it may function as a reflector that reflects light emitted from the light emitting device 130 to the upper part of the substrate 110. For example, the first conductive layer 121a and the second conductive layer 121b of the assembly wiring 120 are made of copper (Cu), chromium (Cr), molybdenum (Mo), and molybdenum titanium (MoTi), the conductive connection member 140 is made of silver (Ag) and may reflect light emitted from the light emitting device 130 toward the upper part of the substrate 110. In particular, the conductive connection member 140, the second conductive layer 121b, and the fourth conductive layer 122b on the side of the light emitting device 130 may improve light efficiency by reflecting light traveling toward the side of the light emitting device 130 toward the top of the substrate 110.

A plurality of assembly wiring connection patterns 120P may be disposed on the second planarization layer 118. The plurality of assembly wiring connection patterns 120P are wires that electrically connect the plurality of assembly wirings 120 to each other. For example, the assembly wiring connection pattern 120P may be connected to the second conductive layer 121b of the first plurality of assembly wirings 121 and the fourth conductive layer 122b of the plurality of second assembly wirings 122 through contact holes formed in the second planarization layer 118, the first planarization layer 117 and the third passivation layer 116. At this time, the assembly wiring connection pattern 120P may be disposed in an area in the plurality of sub-pixels SP where the pixel electrode PE is not disposed.

A plurality of assembly wirings 120 may have the same potential through the assembly wiring connection pattern 120P. That is, the same low-potential voltage may be applied through alternating current to both the plurality of assembly wirings 120 and the assembly wiring connection pattern 120P. At this time, as the assembly wiring connection pattern 120P connects the plurality of assembly wirings 120, the resistance in the plurality of assembly wirings 120 may be improved and the voltage drop phenomenon may be reduced.

The third layer VDD3 of the high-potential power supply line VDD is disposed on the second planarization layer 118. The third layer VDD3 may electrically connect the first layer VDD1 and the second layer VDD2 arranged in different rows. For example, the third layer VDD3 extends in the row direction between the plurality of sub-pixels (SP), and may electrically connect the plurality of second layers VDD2 of the high potential power supply line VDD extending in the column direction to each other. In addition, as the plurality of high-potential power wirings VDD are connected in a mesh form through the third layer VDD3, the voltage drop phenomenon may be reduced.

A black matrix BM is disposed on the second planarization layer 118. The black matrix BM may be disposed between the plurality of sub-pixels SP on the second planarization layer 118. The black matrix (BM) may reduce color mixing between the plurality of sub-pixels (SP). The black matrix (BM) may be made of an opaque material, for example, black resin, but is not limited thereto.

A protective layer 119 is disposed on the pixel electrode (PE), the second planarization layer 118, and the black matrix (BM). The protective layer 119 is a layer to protect the structure below the protective layer 119, and may be composed of a single layer or multiple layers of translucent epoxy, silicon oxide (SiOx), or silicon nitride (SiNx), but is not limited thereto.

Meanwhile, in the plurality of openings 118a, the plurality of assembly wirings 120 are not directly connected to the light emitting device 130, but may be spaced apart by the third passivation layer 116 or the second planarization layer 118. When self-assembling the light emitting device 130, different voltages are to be applied to a pair of assembly wirings 120 arranged adjacent to each other in one opening118a. In order to prevent defects that occur when the light emitting device 130 contacts both of the pair of assembly wirings 120 during the self-assembly process of the light emitting device 130, a third passivation layer 116 is formed on the first conductive layer 121a of the first assembly wiring 121 and the third conductive layer 122a of the second assembly wiring 122, and a second planarization layer 118 is formed on the second conductive layer 121b and the fourth conductive layer 122b, protruding inside the opening 118a from the second conductive layer 121b and the fourth conductive layer 122b, so that there is a technical effect of preventing direct contact between the light emitting device 130 and the assembly wiring 120.

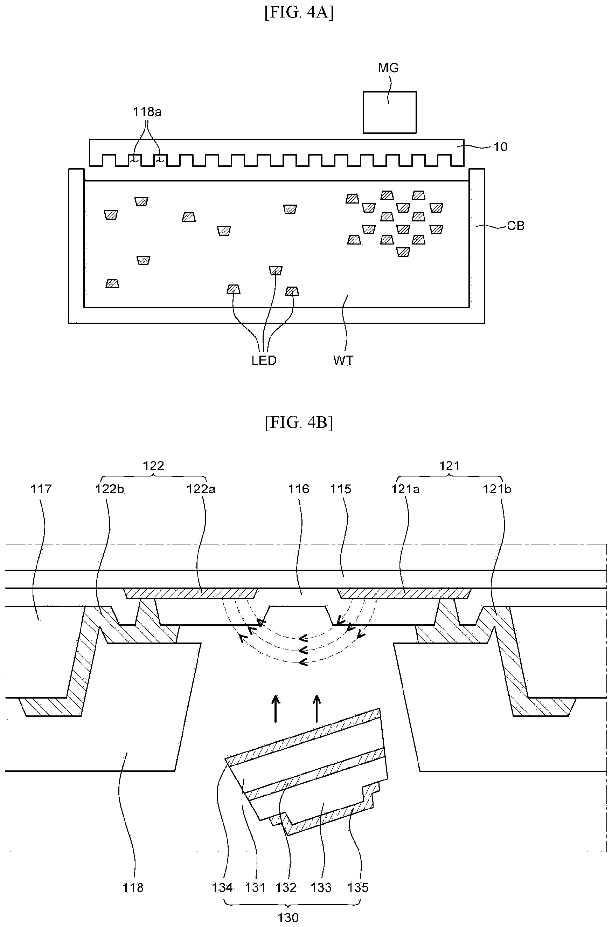

Hereinafter, the manufacturing method of the display device 100 according to the embodiment will be described in detail with reference to FIGS. 4A to 4F.

FIGS. 4A to 4E are process diagrams for explaining a manufacturing method of a display device according to an embodiment. FIGS. 4A to 4E are process diagrams for explaining the process of self-assembling a plurality of light emitting devices 130 into opening 118a.

Referring to FIG. 4A, the light emitting device 130 is introduced into the chamber CB filled with the fluid WT. The fluid WT may include water, etc., and the chamber CB filled with the fluid WT may have an open top.

Next, the mother board 10 may be placed on the chamber CB filled with the light emitting device 130. The mother board 10 is a substrate 110 composed of a plurality of substrates 110 forming the display device 100, when self-assembling the plurality of light emitting devices 130, the mother board 10 formed with the plurality of assembly wirings 120 and the second planarization layer 118 may be used.

Then, the mother board 10 including the assembly wiring 120 and the second planarization layer 118 is placed on the chamber CB or placed into the chamber CB. At this time, the mother board 10 may be positioned so that the opening118a of the second planarization layer 118 and the fluid WT face each other.

Then, the magnet (MG) may be placed on the mother board (10). The Light emitting devices 130 that sink or float on the bottom of the chamber (CB) may move toward the mother board (10) by the magnetic force of the magnet (MG).

At this time, the light emitting device 130 may include a magnetic material to move by a magnetic field. For example, the light emitting device 130 may include a ferromagnetic material such as iron, cobalt, or nickel.

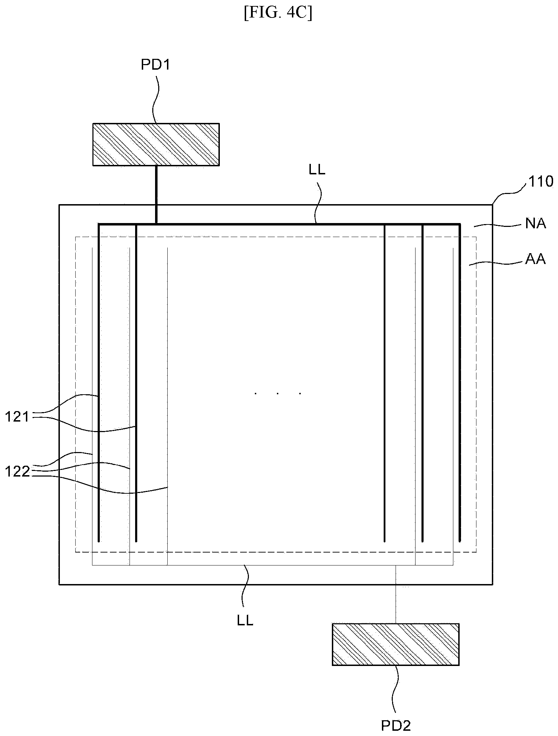

Next, referring to FIGS. 4B and 4C, the light emitting device 130 moved toward the second planarization layer 118 by the magnet MG may be self-assembled in the opening 118a by the electric field formed by the assembly wiring 120.

An alternating voltage may be applied to the plurality of assembly wirings 120 to generate an electric field. The light emitting device 130 may be dielectrically polarized by this electric field to have polarity. And the dielectrically polarized light emitting device 130 may be moved or fixed in a specific direction by dielectrophoresis (DEP), that is, an electric field. Therefore, the plurality of light emitting devices 130 may be fixed within the opening118a of the second planarization layer 118 using dielectrophoresis.

At this time, the same voltage is applied to the pair of first assembly wiring 121 and second assembly wiring 122 overlapping in one opening118a when driving the display device 100, but when manufacturing the display device 100, different voltages are applied. To this end, when manufacturing the display device 100, the first assembly wiring 121 and the second assembly wiring 122 that are adjacent to each other may be connected to different assembly pads and different voltages may be applied.

In this regard, referring to FIG. 4C, when manufacturing the display device 100 and self-assembling the plurality of light emitting devices 130, the plurality of assembly wirings 120 may be connected to the assembly pad. Specifically, on the mother board 10, a plurality of substrates 110 forming the display device 100, a plurality of assembly pads, and a plurality of connection portions for the assembly wiring 120 are disposed.

The plurality of assembly pads are pads for applying voltage to the plurality of assembly wirings 120, and may be electrically connected to a plurality of assembly wirings 120 disposed on each of the plurality of substrates 110 forming the mother board 10. A plurality of assembly pads may be formed on the mother board 10 outside the substrate 110 of the display device 100, when the manufacturing process of the display device 100 is completed, the display device 100 may be separated from the substrate 110. For example, among the plurality of assembly wirings 120, the first assembly wiring 121 is connected to the first assembly pad PD1, and the second assembly wiring 122 is connected to the second assembly pad PD2, so that an electric field may be formed to align the plurality of light emitting devices 130.

At this time, by connecting the plurality of first assembly wirings 121 into one using the link wire LL and connecting the plurality of second assembly wirings 122 into one, all of the plurality of assembly wirings 120 may be easily connected to the assembly pad. For example, the plurality of first assembly wirings 121 may be connected to one through the link wiring LL, and the plurality of second assembly wirings 122 may also be connected to one through the link wiring LL.

Therefore, after placing the mother board 10 in the chamber (CB) into which the plurality of light emitting devices 130 are inserted, an electric field may be formed by applying an alternating voltage to the plurality of assembly wirings 120 through the plurality of assembly pads, and the plurality of light emitting devices 130 may be easily self-assembled into the opening118a.

Next, the mother board 10 may be flipped 180° while the light emitting device 130 is fixed within the opening 118a using the electric field of the plurality of assembly wirings 120. If the mother board 10 is turned over without voltage being applied to the plurality of assembly wirings 120, the plurality of light emitting devices 130 may come off within the opening118a. Therefore, the mother board 10 may be turned over while voltage is applied to the plurality of assembly wirings 120, and subsequent processes may be performed.

After the self-assembly process of the plurality of light emitting devices 130 is completed, the mother board 10 may be cut along the scribing line and separated into a plurality of substrates 110. Thereafter, the same voltage may be easily applied to the plurality of assembly wirings 120 through the link wiring LL that connects the plurality of assembly wirings 120 into one. For example, when driving the display device 100, a voltage may be applied to the plurality of assembly wirings 120 by connecting the link wiring LL that connects each of the plurality of assembly wirings 120 into one and the driving IC.

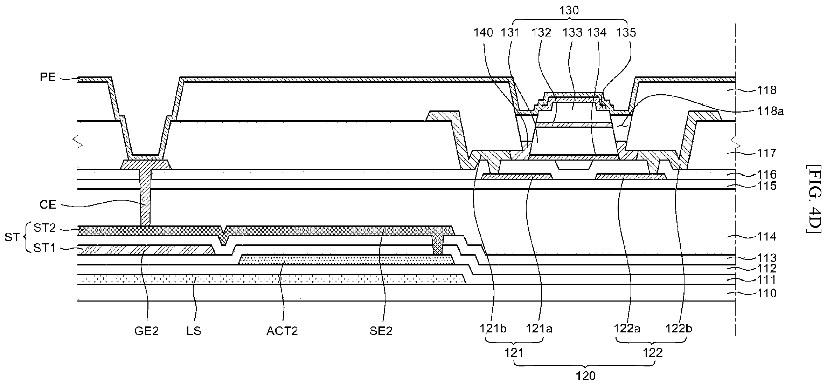

Next, referring to FIG. 4D, a conductive connection member 140 is formed inside the opening118a. By applying a conductive material inside the opening118a, the first semiconductor layer 131 of the light emitting device 130 and the plurality of assembly wirings 120 may be electrically connected.

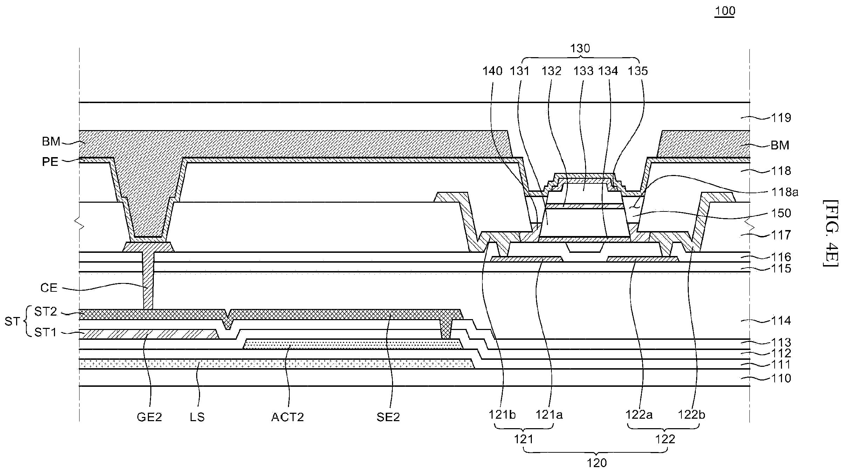

Referring to FIG. 4e, in order to insulate the conductive connection member 140 and the pixel electrode (PE), an insulating member 150 is formed inside the opening118a. By forming an insulating member 150 that fills the inside of opening118a, it is possible to prevent the pixel electrode (PE) and the conductive connection member 140 from being electrically connected.

Next, the pixel electrode PE is formed on the insulating member 150 and the light emitting device 130. The pixel electrode PE may be electrically connected to the second electrode 135 and the second semiconductor layer 133 of the light emitting device 130 exposed from the insulating member 150 inside the opening118a. Additionally, the pixel electrode PE may be electrically connected to the connection electrode CE and the second transistor through the contact holes of the first planarization layer 117 and the second planarization layer 118. Accordingly, the light emitting device 130 and the second transistor may be electrically connected by forming the pixel electrode PE on the second planarization layer 118.

Finally, manufacturing of the display device 100 may be completed by sequentially forming a black matrix (BM) and a protective layer 119 on the entire surface of the substrate 110.

In the display device 100 and its manufacturing method according to the embodiment, the plurality of assembly wirings 120 for self-assembly of the plurality of light emitting devices 130 may be used as wiring for applying a low-potential power supply voltage to the plurality of light emitting devices 130. When manufacturing the display device 100, a plurality of light emitting devices 130 floating in the fluid WT may be moved adjacent to the mother board 10 using a magnetic field. Next, different voltages may be applied to the plurality of assembly wirings 120 to form an electric field, and the plurality of light emitting devices 130 may be self-assembled within the plurality of openings118a by the electric field. At this time, instead of separately forming a wire that supplies a low-potential voltage and connecting it to the plurality of self-assembled light emitting devices 130, the plurality of assembly wirings 120 and the first semiconductor layer 131 of the light emitting device 130 may be electrically connected through the conductive connection member 140, and when driving the display device 100, a plurality of assembly wirings 120 may be used as wiring for supplying low-potential voltage to a plurality of light emitting devices 130.

Therefore, in the display device 100 according to the embodiment, there is a technical effect in that the plurality of assembly wirings 120 may be used not only for self-assembly of the plurality of light emitting devices 130 but also as wiring for driving the plurality of light emitting devices 130.

In the display device 100 and its manufacturing method according to the embodiment, by forming an undercut structure between the second planarization layer 118 covering the assembly wiring 120 and the plurality of assembly wiring 120, it is possible to control the timing of connecting the plurality of assembly wiring 120 and the light emitting device 130. When self-assembling the light emitting device 130, different voltages may be applied to the first assembly wiring 121 and the second assembly wiring 122, and the plurality of assembly wiring 120 and the light emitting device 130 may be in an insulated state. And after self-assembly of the light emitting device 130 is completed, the same voltage is applied to the first assembly wiring 121 and the second assembly wiring 122, the light emitting device 130 may be driven by electrically connecting the first assembly wiring 121 and the second assembly wiring 122 to the light emitting device 130. At this time, the first conductive layer 121a of the first assembly wiring 121 and the third conductive layer 122a of the second assembly wiring 122 are covered with the third passivation layer 116 and may be separated from the light emitting device 130 during the self-assembly process. And the second conductive layer 121b of the first assembly wiring 121 and the fourth conductive layer 122b of the second assembly wiring 122 are covered with a second planarization layer 118 protruding inside the opening118a and may be separated from the light emitting device 130 during the self-assembly process. At this time, the second planarization layer 118 protruding inside the opening118a rather than the assembly wiring 120 may form an undercut structure with the second conductive layer 121b and the fourth conductive layer 122b, ends of the second conductive layer 121b and the fourth conductive layer 122b may be exposed from the second planarization layer 118. Therefore, after self-assembly of the light emitting device 130 is completed, the second conductive layer 121b and the fourth conductive layer 122b may be electrically connected to the light emitting device 130 by forming a conductive connection member 140 that fills the undercut structure.

Accordingly, in the display device 100 according to the embodiment, the second planarization layer 118 and the assembly wiring 120 are formed in an undercut structure, when self-assembling the Light emitting device 130, there is a technical effect in that the light emitting device 130 and the assembly wiring 120 may be separated and easily electrically connected to the light emitting device 130 and the assembly wiring 120 once self-assembly is completed.

In the display device 100 and its manufacturing method according to the embodiment, the second conductive layer 121b and the fourth conductive layer 122b of the assembly wiring 120 extending in the column direction along the plurality of sub-pixels SP are formed on the first planarization layer 117 to reduce parasitic capacitance. A plurality of assembly wirings 120 are formed on a plurality of wirings and a plurality of thin film transistors. However, as the distance between the plurality of assembly wirings 120 and the plurality of wirings or thin film transistors becomes shorter, the possibility of forming parasitic capacitance in the plurality of assembly wirings 120 increases. For example, parasitic capacitance may be formed between the plurality of assembly wirings 120 and the data wire DL. However, when self-assembling the light emitting device 130, the voltage applied to the plurality of assembly wirings 120 may vary due to parasitic capacitance and the self-assembly rate of the light emitting device 130 may decrease. Additionally, when driving the display device 100, parasitic capacitance between the assembly wiring 120, which functions as a low-potential power wiring, and other wiring may affect the driving of the display device 100. Therefore, the second conductive layer 121b of the first assembly wiring 121 and the fourth conductive layer 122b of the second assembly wiring 122, which are disposed across the plurality of sub-pixels (SP), are disposed on the first planarization layer 117, the gap between the second conductive layer 121b and the fourth conductive layer 122b and other components may be increased, and parasitic capacitance may be reduced.

Therefore, in the display device 100 according to the embodiment, there is a technical effect of reducing parasitic capacitance between the plurality of assembly wirings 120 and other components by forming the second conductive layer 121b and the fourth conductive layer 122b of the plurality of assembly wirings 120 on the first planarization layer 117.

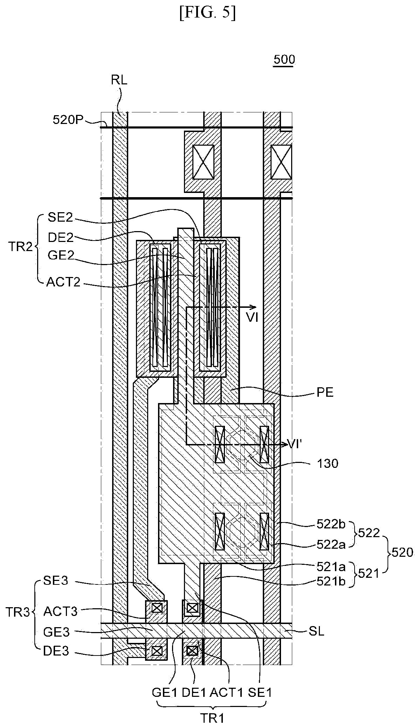

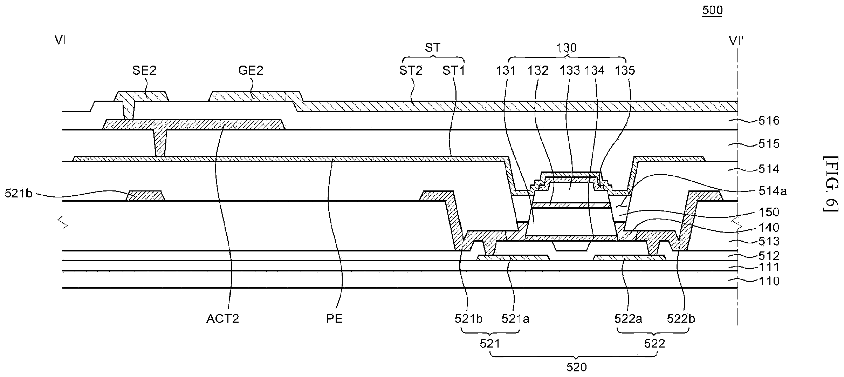

FIG. 5 is an enlarged plan view of a display device according to a second embodiment. FIG. 6 is a cross-sectional view taken along line VI-VI' of FIG. 5. The display device 500 according to the second embodiment may adopt the features of the first embodiment. Hereinafter, the second embodiment will be described with emphasis on the arrangement of a plurality of wires and a plurality of transistors on the light emitting device 130 in the bottom emission method. Referring to FIGS. 5 and 6, a buffer layer 111 may be disposed on the substrate 110 and a plurality of assembly wirings 520 may be disposed on the buffer layer 111. Specifically, the first conductive layer 521a of the first assembly wiring 521 and the third conductive layer 522a of the second assembly wiring 522 may be disposed on the buffer layer 111. The first conductive layer 521a and the third conductive layer 522a are arranged to overlap the opening 514a where the plurality of light emitting devices 130 are seated. The first conductive layer 521a and the third conductive layer 522a may be arranged to overlap one opening 514a at regular intervals. At this time, the first conductive layer 521a and the third conductive layer 522a overlapping the plurality of light emitting devices 130 are made of a transparent conductive material such as indium tin oxide (ITO), indium zinc oxide (IZO), etc., and may emit light emitted from the light emitting device 130 to the lower part of the substrate 110.

The first passivation layer 512 may be disposed on the first conductive layer 521a and the third conductive layer 522a. The first passivation layer 512 is an insulating layer to protect the structure below the first passivation layer 512 and improve the adhesion of the structure formed on the third passivation layer 116, and may be composed of a single layer or multiple layers of silicon oxide (SiOx) or silicon nitride (SiNx), but is not limited thereto.

The first planarization layer 513 may be disposed on the first passivation layer 512. The first planarization layer 513 may be formed so as not to overlap the first conductive layer 521a of the first assembly wiring 521 and the third conductive layer 522a of the second assembly wiring 522. A portion of the first passivation layer 512 covering the first conductive layer 521a may be exposed from the first planarization layer 513. The first planarization layer 513 may be composed of a single layer or a double layer, and may be made of, for example, an acrylic-based organic material, but is not limited thereto.

The second conductive layer 521b of the first assembly wiring 521 and the fourth conductive layer 522b of the second assembly wiring 522 may be disposed on the first planarization layer 513. A portion of the second conductive layer 521b of the first assembly wiring 521 is disposed on the first passivation layer 512 and the first conductive layer (521a), the remaining portion of the second conductive layer 521b may be disposed on the first planarization layer 513. A portion of the fourth conductive layer 522b of the second assembly wiring 522 is disposed on the first passivation layer 512, the remaining portion of the fourth conductive layer 522b may be disposed on the first planarization layer 513. Each of the second conductive layer 521b and the fourth conductive layer 522b may be electrically connected to the first conductive layer 521aand the third conductive layer 522a through the contact hole formed in the first passivation layer 512.

The second planarization layer 514 is disposed on the first planarization layer 513 and the plurality of assembly wirings 520. The second planarization layer 514 may be disposed to cover the plurality of assembly lines 520. The second planarization layer 514 may be composed of a single layer or a double layer, and may be made of, for example, an acrylic-based organic material, but is not limited thereto.

Meanwhile, a portion of the second planarization layer 514 overlapping the plurality of assembly wirings 520 may be open, forming a plurality of openings 514a in which the plurality of light emitting devices 130 are seated. Each of the plurality of openings 514a may be formed to overlap the first conductive layer 521a of the first assembly wiring 521 and the third conductive layer 522a of the second assembly wiring 522. Accordingly, the light emitting device 130 may be self-assembled within the openings 514a by the electric field between the first assembly wiring 521 and the second assembly wiring 522 overlapping the plurality of openings 514a.

Meanwhile, the second planarization layer 514 protrudes inside the opening 514a more than the second conductive layer 521b and the fourth conductive layer 522b. In the opening 514a, the sidewall of the second planarization layer 514 is disposed closer to the light emitting device 130 than one end of the second conductive layer 521b and one end of the fourth conductive layer 522b. As the second planarization layer 514 protrudes more inside the opening 514a than the second conductive layer 521b and the fourth conductive layer 522b, when assembling the light emitting device 130, direct contact between the second conductive layer 521b and the fourth conductive layer 522b and the light emitting device 130 may be prevented.

At this time, in the plurality of openings 514a, the second conductive layer 521b and the second planarization layer 514 and the fourth conductive layer 522b and the second planarization layer 514 may form an undercut structure. The second planarization layer 514 is disposed to cover the second conductive layer 521b and the fourth conductive layer 522b. A portion of the lower portion of the sidewall of the second planarization layer 514 may be removed in the opening 514a, thereby exposing one end of the second conductive layer 521b and one end of the fourth conductive layer 522b from the second planarization layer 514.

A plurality of Light emitting devices 130 are disposed in a plurality of openings514a. Each of the plurality of light emitting devices 130 includes a first semiconductor layer 131, a second semiconductor layer 133, a light emitting layer 132, a first electrode 134, and a second electrode 135.

The second semiconductor layer 133 may be disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may be layers doped with p-type or n-type impurities in materials such as gallium nitride (GaN), indium aluminum phosphide (InAlP), and gallium arsenide (GaAs). The p-type impurities may be magnesium (Mg), zinc (Zn), beryllium (Be), etc., and the n-type impurities may be silicon (Si), germanium (Ge), tin (Sn), etc., but are not limited thereto.

The light emitting layer 132 may be disposed between the first semiconductor layer 131 and the second semiconductor layer 133. The light emitting layer 132 may emit light by receiving holes and electrons from the first semiconductor layer 131 and the second semiconductor layer 133. The light emitting layer 132 may be made of a single-layer or multi-quantum well (MQW) structure, and may be made of, for example, indium gallium nitride (InGaN) or gallium nitride (GaN), but is not limited thereto.

The first electrode 134 may be disposed on the lower surface of the first semiconductor layer 131, and the second electrode 135 may be disposed on the upper surface of the second semiconductor layer 133. The first electrode 134 is an electrode electrically connected to the assembly wiring 520, and the second electrode 135 is an electrode that electrically connects a pixel electrode (PE), which will be described later, and the second semiconductor layer 133. The first electrode 134 and the second electrode 135 may be formed of a conductive material. However, the first electrode 134 may be omitted depending on the design, but is not limited thereto.

Meanwhile, although not shown in the drawing, an insulating layer surrounding a portion of each of the plurality of light emitting devices 130 may be disposed. Specifically, the insulating layer may cover at least the side surface of the light emitting device 130 among the outer surfaces of the plurality of light emitting devices 130. Protecting the light emitting device 130 by forming an insulating layer on the light emitting device 130, when forming the first electrode 134 and the second electrode 135, electrical short circuit between the first semiconductor layer 131 and the second semiconductor layer 133 may be prevented.

A conductive connection member 140 surrounding the lower side of the light emitting device 130 is disposed in opening514a. The conductive connection member 140 is filled in the space inside the opening514a and may fix the light emitting device 130.

In addition, the conductive connection member 140 is filled inside the opening514a, and may electrically connect the first semiconductor layer 131 and the first electrode 134 of the light emitting device 130 and the assembly wiring 520. For example, the conductive connection member 140 surrounding the first semiconductor layer 131 and the first electrode 134 fills the empty space between the third planarization layer 515 and the third passivation layer 116 and may contact the second conductive layer 521b and the fourth conductive layer 522b. Accordingly, the first assembly wiring 521, the second assembly wiring 522, and the first semiconductor layer 131 of the light emitting device 130 may be electrically connected to each other by the conductive connection member 140. The conductive connection member 140 is made of a conductive material such as silver (Ag) and may be formed through an inkjet printing process, but is not limited thereto.

An insulating member 150 is disposed inside the opening514a. The insulating member 150 is filled inside the opening514a, may cover the conductive connection member 140, and may surround the side of the light emitting device 130. For example, the insulating member 150 may surround a portion of the side of the light emitting device 130 including the light-emitting layer 132 and cover all of the conductive connection member 140 exposed at opening514a. Accordingly, the pixel electrode (PE), which will be described later, and the conductive connection member 140 are electrically connected to prevent short circuit defects from occurring.

The pixel electrode (PE) may be disposed on the insulating member 150 and the second planarization layer 514. The pixel electrode (PE) is an electrode for electrically connecting the plurality of Light emitting devices 130 and the second transistor.

Meanwhile, the display device 500 according to the second embodiment is a bottom emission type display device 500. In this case, the pixel electrode PE is made of a metal material with high reflectivity and may reflect light emitted from the light emitting device 130 toward the lower part of the substrate 110. In particular, the pixel electrode PE covering the upper part of the light emitting device 130 is formed to correspond to the shape of the upper part of the light emitting device 130, and may function as a concave cup-shaped reflector. Additionally, since the pixel electrode PE covers the entire upper portion of the light emitting device 130 without any gaps, it is possible to minimize light emitted from the light emitting device 130 from being directed toward the top of the substrate 110.

Therefore, because the concave cup-shaped pixel electrode (PE) covers the entire upper part of the light emitting device 130, there is a technical effect in that light emitted from the light emitting device 130 may be more easily reflected to the lower part of the substrate 110 and light extraction efficiency may be improved.

The first transistor TR1, the second transistor, the third transistor, and the storage capacitor ST may be disposed on the second planarization layer 514.

Referring to FIG. 5, the first transistor TR1 may be disposed on the second planarization layer 514. The first transistor TR1 includes a first active layer ACT1, a first gate electrode GE1, a first source electrode SE1, and a first drain electrode DE1.

The first source electrode SE1 and the first drain electrode DE1 of the first transistor TR1 may be disposed on the second planarization layer 514. The first source electrode (SE1) and the first drain electrode (DE1) are made of a conductive material, such as copper (Cu), aluminum (Al), molybdenum (Mo), nickel (Ni), titanium (Ti), chromium (Cr) or an alloy thereof, but is not limited thereto.

The third planarization layer 515 is disposed on the first source electrode (SE1) and the first drain electrode (DE1), and the first active layer (ACT1) is disposed on the third planarization layer 515. The first active layer (ACT1) may be made of a semiconductor material such as oxide semiconductor, amorphous silicon, or polysilicon, but is not limited thereto.

A gate insulating layer 516 is disposed on the first active layer ACT1. The gate insulating layer 516 is an insulating layer for insulating the first active layer (ACT1) and the first gate electrode (GE1), and may be composed of a single layer or multiple layers of silicon oxide (SiOx) or silicon nitride (SiNx), but is not limited to this.

The first gate electrode GE1 may be disposed on the gate insulating layer 516. The first gate electrode GE1 is electrically connected to the scan line SL, and the first transistor TR1 may be turned on or off by a scan signal from the scan line SL. The first gate electrode GE1 is made of a conductive material, such as copper (Cu), aluminum (Al), molybdenum (Mo), nickel (Ni), titanium (Ti), chromium (Cr), or an alloy thereof, but is not limited to this.

Meanwhile, the data line DL is not shown in FIG. 5 for convenience of explanation, but the first drain electrode DE1 of the first transistor TR1 may be connected to the data line DL. The arrangement and connection structure of the data line (DL) may be configured in various ways depending on the design.

The second transistor may be disposed on the second planarization layer 514. The second transistor includes a second active layer (ACT2), a second gate electrode (GE2), a second source electrode (SE2), and a second drain electrode (DE2).

The second active layer ACT2 may be disposed on the second planarization layer 514 and the third planarization layer 515. The second active layer (ACT2) may be made of a semiconductor material such as oxide semiconductor, amorphous silicon, or polysilicon, but is not limited thereto.

The gate insulating layer 516 is disposed on the second active layer ACT2, the second gate electrode GE2, the second source electrode SE2, and the second drain electrode DE2 may be disposed on the gate insulating layer 516. The second gate electrode GE2 may be electrically connected to the first source electrode SE1. The second source electrode (SE2), the second drain electrode (DE2), and the second gate electrode (GE2) are made of a conductive material, such as copper (Cu), aluminum (Al), molybdenum (Mo), and nickel (Ni)., titanium (Ti), chromium (Cr), or an alloy thereof, but is not limited thereto.

Meanwhile, in FIG. 5, the high-potential power supply wiring VDD is not shown for convenience of explanation. The second drain electrode DE2 of the second transistor may be connected to the high potential power line VDD. The arrangement and connection structure of the high-potential power wiring VDD may be configured in various ways depending on the design.

The reference wiring RL and the third transistor may be disposed on the second planarization layer 514. The third transistor includes a third active layer (ACT3), a third gate electrode (GE3), a third source electrode (SE3), and a third drain electrode (DE3).

The third source electrode SE3 and the third drain electrode DE3 may be disposed on the second planarization layer 514. The third drain electrode DE3 may be electrically connected to the reference line RL, and the third source electrode SE3 may be electrically connected to the second transistor. The third source electrode (SE3) and the third drain electrode (DE3) are made of a conductive material, such as copper (Cu), aluminum (Al), molybdenum (Mo), nickel (Ni), titanium (Ti), chromium (Cr) or an alloy thereof, but is not limited thereto.

The third planarization layer 515 is disposed on the third source electrode (SE3) and the third drain electrode (DE3), the third active layer ACT3 may be disposed on the third planarization layer 515. The third active layer (ACT3) may be made of a semiconductor material such as oxide semiconductor, amorphous silicon, or polysilicon, but is not limited thereto.

The gate insulating layer 516 may be disposed on the third active layer ACT3, and the third gate electrode GE3 may be disposed on the gate insulating layer 516. The third gate electrode GE3 is connected to the scan line SL, and the third transistor may be turned on or off by the scan signal. The third gate electrode GE3 is made of a conductive material, such as copper (Cu), aluminum (Al), molybdenum (Mo), nickel (Ni), titanium (Ti), chromium (Cr), or an alloy thereof, but is not limited to this.

A storage capacitor (ST) may be disposed on the second planarization layer 514. The storage capacitor ST includes a first capacitor electrode ST1 and a second capacitor electrode ST2. The storage capacitor (ST) is connected between the second gate electrode (GE2) and the second source electrode (SE2) of the second transistor, and may store voltage and maintain the voltage level of the gate electrode of the second transistor constant while the light emitting device 130 emits light.

The first capacitor electrode ST1 may be formed integrally with the pixel electrode PE. Additionally, the first capacitor electrode ST1 may be electrically connected to the second source electrode SE2 through the second active layer ACT2.

The second capacitor electrode ST2 may be disposed on the first capacitor electrode ST1 with the third planarization layer 515 and the gate insulating layer 516 interposed therebetween. The second capacitor electrode (ST2) may be integrated with the second gate electrode (GE2) of the second transistor. Accordingly, the second capacitor electrode ST2 may be electrically connected to the second gate electrode GE2 of the second transistor and the first source electrode SE1 of the first transistor TR1.

The assembly wiring connection pattern 520P is disposed on the second planarization layer 514. The plurality of assembly wiring connection patterns 520P may electrically connect the plurality of assembly wiring 520 to each other. For example, the assembly wiring connection pattern 520P may be connected to the second conductive layer 521b of the plurality of assembly wirings 520 through a contact hole formed in the second planarization layer 514. However, the assembly wiring connection pattern 520P may be disposed on the third planarization layer 515 or the gate insulating layer 516, but is not limited thereto.

The display device 500 according to the second embodiment may improve the light extraction efficiency of the display device 500 by applying the bottom emission method. In the case of the bottom emission method, after self-assembling the light emitting device 130, a pixel electrode (PE), a plurality of wirings, and a plurality of thin film transistors are formed on the light emitting device 130. At this time, when the pixel electrode (PE) covering the light emitting device 130 is formed of a material with high reflectivity, the pixel electrode (PE) may function as a reflector that reflects the light emitted from the light emitting device 130 toward the substrate 110. Additionally, the pixel electrode PE formed along the convex upper portion of the light emitting device 130 may be formed in a concave cup shape. Accordingly, the light emitted from the light emitting device 130 may be efficiently reflected to the lower part of the light emitting device 130.

Therefore, in the display device 500 according to the second embodiment, there is a technical effect that may improve the light extraction efficiency of the display device 500 by forming the display device 500 using the bottom emission method, and the pixel electrode (PE) covering the Light emitting device 130 functions as a cup-shaped reflector.

In the display device 500 according to the second embodiment, after self-assembling the light emitting device 130, a plurality of wirings and a plurality of thin film transistors are formed on the light emitting device 130, so that the structure of the display device 500 may be simplified. When the display device 500 is configured using the bottom emission method, after self-assembling the light emitting device 130, a pixel electrode (PE) or a plurality of thin film transistors, etc. may be formed on the light emitting device 130. At this time, the structure of the display device 500 may be simplified as a plurality of thin film transistors and a plurality of wirings are formed on the pixel electrode PE.

For example, since the second transistor is formed directly on the pixel electrode (PE), the pixel electrode (PE) and the second transistor may be directly connected, so the intermediate medium connecting the pixel electrode (PE) and the second transistor may be simplified.

For example, the formation process of the storage capacitor (ST) and the pixel electrode (PE) may be simplified by using the pixel electrode (PE) as a capacitor electrode of the storage capacitor (ST). In addition, in the bottom emission method, the assembly wiring 520 is formed before other configurations, since other components are formed after self-assembly, the insulating layer added to increase the gap between the assembly wiring 520 and other components to reduce parasitic capacitance may be simplified.

Therefore, in the display device 500 according to the second embodiment, the structure of the display device 500 may be simplified by implementing the display device 500 using a bottom emission method that forms a plurality of wirings and a plurality of thin film transistors after self-assembly of the light emitting device 130.

In the display device 500 according to the second embodiment, by applying the bottom emission method, when self-assembling the light emitting device 130, the parasitic capacitance of the assembly wiring 520 may be reduced and the assembly rate may be improved. In the bottom emission method, the light emitting device 130 is self-assembled with a plurality of assembly wirings 520 and the first and second planarization layers 513 and 514 formed, and a plurality of thin film transistors and a plurality of wirings may be formed on the light emitting device 130. In other words, when self-assembling the light emitting device 130, since no wiring other than the plurality of assembly wirings 520 is formed, parasitic capacitance between the plurality of assembly wirings 520 and other wirings may be prevented during the self-assembly process, and the assembly rate of the light emitting device 130 may be improved.

Accordingly, in the display device 500 according to the second embodiment, after self-assembling the Light emitting device 130, the display device 500 is implemented using a bottom emission method that forms a plurality of wires and a thin film transistor on the light emitting device 130, so there is a complex technical effect of preventing parasitic capacitance of the plurality of assembly wirings 520 and improving the self-assembly rate of the light emitting device 130.

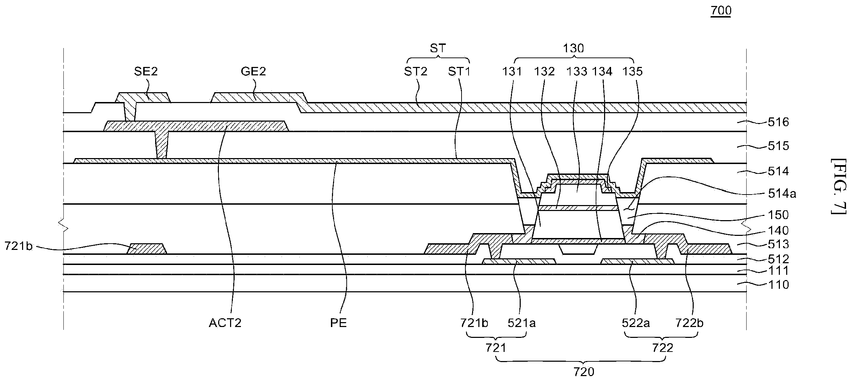

FIG. 7 is a cross-sectional view of a display device according to a third embodiment. The display device 700 according to the third embodiment may adopt the features of the second embodiment. Hereinafter, the description will focus on the form of the assembly wiring 720. Referring to FIG. 7, the second conductive layer 721b of the first assembly wiring 721 and the fourth conductive layer 722b of the second assembly wiring 722 are disposed between the first planarization layer 513 and the first passivation layer 512. Each of the second conductive layer 721b and the fourth conductive layer 722b may be electrically connected to the first conductive layer 521a and the third conductive layer 522a through contact holes formed in the first passivation layer 512.

The first planarization layer 513 and the second planarization layer 514 may be disposed on the second conductive layer 721b and the fourth conductive layer 722b. An opening514a in which a plurality of light emitting devices 130 are disposed is formed in the first planarization layer 513 and the second planarization layer 514. At this time, the first planarization layer 513 and the second planarization layer 514 may protrude inside the opening514a more than the second conductive layer 721b and the fourth conductive layer 722b. Accordingly, when assembling the light emitting device 130, direct contact between the second conductive layer 721b and the fourth conductive layer 722b and the light emitting device 130 may be prevented.

And the first planarization layer 513 may form an undercut structure with the second conductive layer 721b and the fourth conductive layer 722b. The first planarization layer 513 is disposed to cover the second conductive layer 721b and the fourth conductive layer 722b, but the space from opening514a to one end of the second conductive layer 721b and the space from opening514a to one end of the fourth conductive layer 722b are not filled with the first planarization layer 513, and the end of the second conductive layer 721b and the end of the fourth conductive layer 722b may be exposed from the first planarization layer 513.

In the display device 700 according to the third embodiment, the parasitic capacitance of the assembly wiring 720 is not limited, and the arrangement of the assembly wiring 720 may be designed in various ways. In the case of the bottom emission method, the light emitting device 130 is self-assembled with a plurality of assembly wirings 720 and the first and second planarization layers 513 and 514 formed, a plurality of thin film transistors or a plurality of wirings may be formed on the light emitting device 130. That is, when self-assembling the light emitting device 130, no wiring other than the plurality of assembly wirings 720 is formed, so that parasitic capacitance between the plurality of assembly wirings 720 and other wires may be prevented, and the assembly rate of the light emitting device 130 may be improved. Therefore, there is a technical effect in that the structure of the plurality of assembly wirings 720 may be designed in various ways without considering the relationship with other wirings.

For example, as shown in FIG. 7, the second conductive layer 721b of the first assembly wiring 721 and the fourth conductive layer 722b of the second assembly wiring 722 may be formed on the first passivation layer 512 or on the first planarization layer 513.

Accordingly, in the display device 700 according to the third embodiment, after self-assembling the Light emitting device 130, as the bottom emission method is used to form a plurality of wires and a thin film transistor on the light emitting device 130, there is a technical effect of preventing parasitic capacitance of the plurality of assembly wirings 720 and improving the design freedom of the plurality of assembly wirings 720.

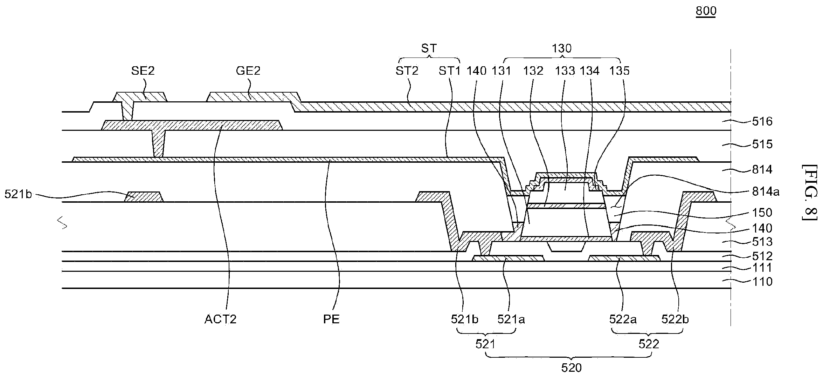

FIG. 8 is a cross-sectional view of a display device according to a fourth embodiment. The display device 800 according to the fourth embodiment may adopt the features of the second embodiment. Hereinafter, the description will focus on the second planarization layer 1814. Referring to FIG. 8, the second planarization layer 814 may be disposed on the plurality of assembly lines 520. The second planarization layer 814 may cover the second conductive layer 521b of the first assembly wiring 521 and the fourth conductive layer 522b of the second assembly wiring 522. At this time, the second planarization layer 814 and the second conductive layer 521b may form an undercut structure, and the end of the second conductive layer 521b of the first assembly wiring 521 may be exposed from the second planarization layer 814. Accordingly, the conductive connection member 140 filled inside the opening (814a) contacts the end of the second conductive layer 521b exposed from the second planarization layer 814, so the light emitting device 130 and the first assembly wiring 521 may be electrically connected.

On the other hand, the second planarization layer 814 is arranged to cover the entire fourth conductive layer 522b of the second assembly wiring 522. The end of the second conductive layer 521b of the first assembly wiring 521 is exposed from the second planarization layer 814, but the end of the fourth conductive layer 522b of the second assembly wiring 522 is not exposed from the second planarization layer 814. Therefore, the conductive connection member 140 filled inside the opening 814a cannot be directly connected to the fourth conductive layer 522b.

In the display device 800 according to the third embodiment, only one of the first assembly wiring 521 and the second assembly wiring 522 is exposed inside the opening 814a, so that there is a technical effect of improving short circuit defects between the first assembly wiring 521 and the second assembly wiring 522. When self-assembling the light emitting device 130, different voltages may be applied to the first assembly wiring 521 and the second assembly wiring 522.

However, when both the second conductive layer 521b of the first assembly wiring 521 and the fourth conductive layer 522b of the second assembly wiring 522 are exposed from the second planarization layer 814 inside the opening (814a), a short circuit may occur between the second conductive layer 521b and the fourth conductive layer 522b due to foreign substances, etc. Therefore, short circuit defects between the first assembly wiring 521 and the second assembly wiring 522 may be reduced by completely covering one of the first assembly wiring 521 and the second assembly wiring 522 with the second planarization layer 814. Additionally, as one of the first assembly wiring 521 and the second assembly wiring 522 is exposed from the second planarization layer 814, after self-assembly of the light emitting device 130 is completed, the light emitting device 130 and the assembly wiring 520 may be electrically connected by forming a conductive connection member 140.

Therefore, in the display device 800 according to the third embodiment, there is a technical effect of minimizing the occurrence of short circuit defects during the self-assembly process of the light emitting device 130 by directly exposing only one of the first assembly wiring 521 and the second assembly wiring 522 to the inside of the opening 814a.

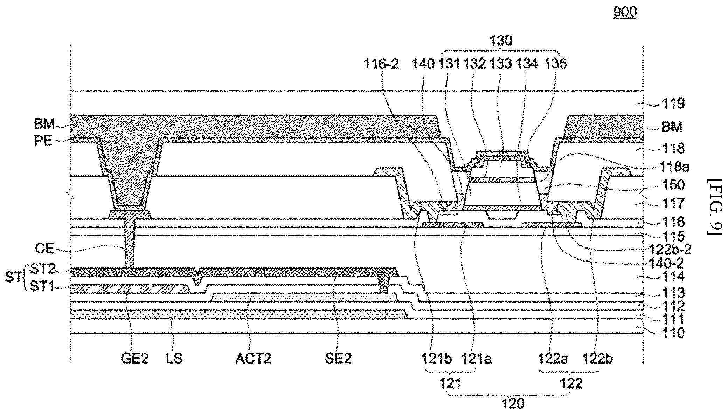

FIG. 9 is a cross-sectional view of the display device 900 according to the fourth embodiment. The display device 900 according to the fourth embodiment may adopt the features of the first embodiment. For example, as the fourth embodiment arranges the second conductive layer 121b and the fourth conductive layer 122b, which have a relatively thicker thickness than the first conductive layer 121a and the third conductive layer 122a, there is a technical effect of minimizing problems such as heat generation or power consumption due to resistance in the first assembly wiring 121 and the second assembly wiring 122. Hereinafter, the description will focus on the shape of the third passivation layer 116.

Referring to FIG. 9, the third passivation layer 116 is disposed on the first conductive layer 121a and the third conductive layer 122a. At this time, the third passivation layer 116 may have a recess 116-2 formed in an area in contact with the plurality of conductive connection members 140. In detail, the recess 116-2 contacts the plurality of conductive connection members 140 and may be formed to contact at least one of the second conductive layer 121b or the fourth conductive layer 122b. The recess 116-2 may be formed in plural numbers.

Additionally, when forming the plurality of conductive connection members 140 using an inkjet printing process, etc., the plurality of conductive connection members 140 may be formed within the recess 116-2. Additionally, at least one of the second conductive layer 121b or the fourth conductive layer 122b may be formed in the recess 116-2.

Therefore, due to the recess 116-2, the conductive connection member 140 may be formed to have a large thickness in the area in contact with the plurality of assembly wirings 120, accordingly, it is possible to prevent the problem of the conductive connection member 140 and the assembly wiring 120 not being connected, and the contact area increases due to the large thickness, which has a complex technical effect of reducing resistance and increasing the amount of current.

The display device according to the embodiment has the technical effect of being able to utilize the wiring for self-assembly of the light emitting device as the wiring for driving the light emitting device.

In addition, the embodiment has the technical effect of minimizing defects during self-assembly or bonding of light emitting devices by improving the structure of a plurality of assembly wirings.

Additionally, the embodiment has the technical effect of minimizing short circuit defects in a plurality of assembly wiring.

Additionally, the embodiment has a technical effect of improving the resistance of a plurality of assembly wiring.

In addition, the embodiment has complex technical effects that may reduce parasitic capacitance of a plurality of assembly wirings and improve the assembly rate of light emitting devices.

In addition, as the embodiment forms a plurality of assembly lines and a planarization layer in an undercut structure, there is a special technical effect in that a plurality of assembly wirings and a light emitting device may be insulated during assembly, and a plurality of assembly wirings and a light emitting device may be easily electrically connected after assembly is completed.

In addition, the embodiment has the technical effect of simplifying the structure of the display device by configuring the display device in a bottom emission method.

In addition, the embodiment has the technical effect of improving the light extraction efficiency of the display device by configuring the display device in a bottom emission method.

In addition, the embodiment has the technical effect of preventing the issue of short circuiting the wiring for driving the light emitting device by forming the conductive member thickly.

Additionally, the embodiment has the technical effect of increasing the amount of current transmitted to the light emitting device when driving the light emitting device by increasing the contact area between the conductive member and the assembly wiring.

The above detailed description is not to be construed as restrictive in any respect and is to be considered illustrative. The scope of the embodiment is to be determined by reasonable interpretation of the appended claims, and all changes within the equivalent scope of the embodiment are included in the scope of the embodiment.

### [Explanation of cited reference]

100, 500, 700, 800: Display devices
AA: Display area NA: Non-display area
SP: Sub-pixel 110: Substrate
111: buffer layer 112, 512: first passivation layer
113, 516: gate insulating layer 114: over coating layer
115: second passivation layer 116: third passivation layer
116-2: Recess 117, 513: First planarization layer
118, 514, 814: second planarization layer 119: protective layer
515: third planarization layer 118a, 514a, 814a: opening
120, 520, 720: Assembly wiring 121, 521, 721: First assembly wiring
121a, 521a: first conductive layer 121b, 521b, 721b: second conductive layer
122, 522, 722: second assembly wiring 122a, 522a: third conductive layer
122b, 122b2, 522b, 722b: fourth conductive layer
120P, 520P: Assembly wiring connection pattern 130: light emitting device
131: first semiconductor layer 132: light emitting layer
133: second semiconductor layer 134: first electrode
135: second electrode 140, 140-2: conductive connection member
150: Insulating member SL: Scan wiring
DL: Data wiring RL: Reference wiring
VDD: High potential power wiring VDD1: 1stlayer
VDD2: Second layer VDD3: Third layer
TR1: first transistor ACT1: first active layer
GE1: first gate electrode SE1: first source electrode
DE1: first drain electrode TR2: second transistor
ACT2: second active layer GE2: second gate electrode
SE2: second source electrode DE2: second drain electrode
TR3: third transistor ACT3: third active layer
GE3: third gate electrode SE3: third source electrode
DE3: Third drain electrode ST: Storage capacitor
ST1: first capacitor electrode ST2: second capacitor electrode
LS: Light blocking layer PE: Pixel electrode
CE: Connection electrode BM: Black matrix
WT: Fluid CB: Chamber
MG: magnet 10: mother board
PD1: First assembly pad PD2: Second assembly pad
LL: Link Wiring

### [Industrial applicability]

The embodiment may be adopted in the field of displays that display images or information.

The embodiment may be adopted in the display field to display images or information using a semiconductor light emitting device.

The embodiment may be adopted in the display field to display images or information using a micro- or nano-level semiconductor light emitting device.

## Claims

1. A display device including a semiconductor light emitting device comprising:
a substrate;
a plurality of assembly wirings disposed on the substrate and comprising a first assembly wiring and a second assembly wiring arranged alternately;
a planarization layer having a plurality of openings overlapping the plurality of assembly wirings;
a plurality of light emitting devices disposed in each of the plurality of openings; and
a plurality of conductive connection members disposed in each of the plurality of openings and electrically connecting the plurality of assembly wirings and the plurality of light emitting devices,
wherein the planarization layer is configured to protrude inside the plurality of openings beyond one end of the plurality of assembly wirings, and
wherein one end of the plurality of assembly wiring is exposed from the planarization layer and is in contact with the plurality of conductive connection members.

2. The display device including the semiconductor light emitting device according to claim 1,
wherein the first assembly wiring comprises a first conductive layer disposed on the substrate and a second conductive layer disposed on the first conductive layer,
wherein the second assembly wiring comprises a third conductive layer disposed on the substrate and a fourth conductive layer disposed on the third conductive layer,
wherein the first conductive layer and the third conductive layer overlap the plurality of openings, and
wherein the second conductive layer and the fourth conductive layer are spaced apart from the openings.

3. The display device including the semiconductor light emitting device according to claim 2,
further comprising a passivation layer disposed between the first conductive layer and the third conductive layer and the plurality of the light emitting devices,
wherein the second conductive layer is electrically connected to the first conductive layer through a contact hole in the passivation layer, and
wherein the fourth conductive layer is electrically connected to the third conductive layer through a contact hole in the passivation layer.

4. The display device including the semiconductor light emitting device according to claim 3, wherein a sidewall of the planarization is disposed closer to the plurality of light emitting devices than the second conductive layer and the fourth conductive layer in the plurality of openings.

5. The display device including the semiconductor light emitting device according to claim 4, wherein the planarization layer and the second conductive layer are configured to form an undercut structure, and one end of the second conductive layer is exposed from the planarization layer, and
wherein the plurality of conductive connection members are configured to fill insides of the plurality of openings and are contact with lower sides of the plurality of light emitting devices and one end of the second conductive layer.

6. The display device including a semiconductor light emitting device according to claim 5,
wherein the planarization layer and the fourth conductive layer are configured to form an undercut structure, so that one end of the fourth conductive layer is exposed from the planarization layer, and
wherein the plurality of conductive connection members are configured to fill insides of the plurality of openings and are configured to contact one end of the fourth conductive layer.

7. The display device including the semiconductor light emitting device according to claim 5, wherein the planarization layer is configured to cover one end of the fourth conductive layer, and
wherein the plurality of conductive connection members are separated from the fourth conductive layer by the planarization layer.

8. The display device including the semiconductor light emitting device according to claim 1, further comprising:
a plurality of pixel electrodes disposed on the planarization layer and electrically connected to the plurality of light emitting devices and;
a plurality of insulating members disposed between the plurality of conductive connection members and the plurality of pixel electrodes in each of the plurality of openings.

9. The display device including the semiconductor light emitting device according to claim 8,
further comprising a plurality of driving transistors disposed between the substrate and the plurality of assembly wirings, and
wherein the plurality of pixel electrodes electrically are configured to connect the plurality of driving transistors and the plurality of light emitting devices through contact holes in the planarization layer.

10. The display device including the semiconductor light emitting device according to claim 8, further comprising a plurality of driving transistors disposed on the plurality of pixel electrodes, and
wherein the plurality of pixel electrodes are reflective electrodes.

11. A display device including a semiconductor light emitting device comprising:
a substrate;
a plurality of first conductive layers and a plurality of third conductive layers arranged alternately on the substrate and spaced apart from each other;
a passivation layer disposed on the plurality of first conductive layers and the plurality of third conductive layers;
a plurality of second conductive layers disposed on the passivation layer and electrically connected to each of the plurality of first conductive layers;
a plurality of fourth conductive layers disposed on the passivation layer and electrically connected to each of the plurality of third conductive layers;
a planarization layer disposed on the plurality of second conductive layers and the plurality of fourth conductive layers and having a plurality of openings overlapping with the plurality of first conductive layers and the plurality of third conductive layers;
a plurality of light emitting devices disposed in each of the plurality of openings, each comprising a first semiconductor layer and a second semiconductor layer disposed on the first semiconductor layer; and
a plurality of conductive connection members surrounding the first semiconductor layer in the plurality of openings, and
wherein one end of the plurality of second conductive layers is exposed from the planarization layer and is in contact with the plurality of conductive connection members.

12. The display device including the semiconductor light emitting device according to claim 11,
wherein the planarization layer is configured to protrude inside the plurality of openings beyond one end of the plurality of second conductive layers, and
wherein the planarization layer and the plurality of second conductive layers are configured to form an undercut structure in which one end of the plurality of second conductive layers is exposed from the planarization layer.

13. The display device including the semiconductor light emitting device according to claim 11, wherein the planarization layer comprises:
a first planarization layer disposed between the plurality of second conductive layers and the passivation layer and between the plurality of fourth conductive layers and the passivation layer and
a second planarization layer disposed on the plurality of second conductive layers and the plurality of fourth conductive layers and comprising the plurality of openings,
wherein a portion of the plurality of second conductive layers and a portion of the plurality of fourth conductive layers are disposed between the passivation layer and the second planarization layer,
wherein a remaining portion of the plurality of second conductive layers and a remaining portion of the plurality of fourth conductive layers are disposed between the first planarization layer and the second planarization layer.

14. The display device including the semiconductor light emitting device according to claim 11, wherein one end of the plurality of fourth conductive layers is exposed from the planarization layer and is configured to contact with the plurality of conductive connection members.

15. The display device including the semiconductor light emitting device according to claim 11, wherein one end of the plurality of fourth conductive layers is covered by the planarization layer and is spaced apart from the plurality of conductive connection members.

16. The display device including the semiconductor light emitting device according to claim 11, further comprising:
a plurality of pixel electrodes disposed on the planarization layer and electrically connected to the second semiconductor layer of each of the plurality of light emitting devices and
a plurality of insulating members surrounding the plurality of light emitting devices between the plurality of pixel electrodes and the plurality of conductive connection members.

17. The display device including the semiconductor light emitting device according to claim 16, further comprising a plurality of driving transistors disposed between the passivation layer and the substrate and electrically connected to the plurality of pixel electrodes.

18. The display device including the semiconductor light emitting device according to claim 16, further comprising a plurality of driving transistors disposed on the plurality of pixel electrodes, and
wherein the plurality of pixel electrodes are configured to form gate electrodes of the plurality of driving transistors and storage capacitors.

19. The display device including the semiconductor light emitting device according to claim 1,
wherein the passivation layer comprises a recess in an area in contact with the plurality of conductive connection members.

20. The display device including the semiconductor light emitting device according to claim 19, wherein the plurality of conductive connection members and the assembly wiring are disposed in the recess of the passivation layer.
